# EUROPÄISCHE PATENTSCHRIFT

(11) **EP 2 200 105 B1**
(45) Veröffentlichungstag und Bekanntmachung des Hinweises auf die Patenterteilung: **01.05.2013**
(21) Anmeldenummer: 09177827.4
(22) Anmeldetag: 03.12.2009
(51) Int. Cl.: H01L 51/52, H01L 51/44, H01L 51/10

(54) **Verfahren zur Verkapselung einer elektronischen Anordnung**
Method for encapsulation of an electronic assembly
Procédé d'encapsulation d'un agencement électronique

(30) Priorität: 16.12.2008 DE 102008062130
(43) Veröffentlichungstag der Anmeldung: 23.06.2010
(73) Patentinhaber: tesa SE, 20253 Hamburg (DE)
(72) Erfinder: Keite-Telgenbüscher, Dr. Klaus, 22529, Hamburg (DE); Müssig, Dr. Bernhard, 21218, Seevetal (DE); Ellinger, Jan, 20257, Hamburg (DE); METZLER, Kerstin, CH-1225 Chène-Bourg (CH)

(56) Entgegenhaltungen:
- EP-A1- 1 955 844
- WO-A1-2007/087281
- WO-A2-01/92344
- WO-A2-2008/036707
- US-A- 6 143 818

## Beschreibung

Die vorliegende Erfindung betrifft ein Verfahren zur Kapselung einer elektronischen Anordnung sowie die Verwendung einer Haftklebemasse zur Kapselung einer elektronischen Anordnung

Elektronische Anordnungen, insbesondere optoelektronische Anordnungen, werden immer häufiger in kommerziellen Produkten verwendet oder stehen kurz vor der Markteinführung. Derartige Anordnungen umfassen anorganische oder organische elektronische Strukturen, beispielsweise organische, metallorganische oder polymere Halbleiter oder auch Kombinationen dieser. Diese Anordnungen und Produkte sind je nach gewünschter Anwendung starr oder flexibel ausgebildet, wobei eine zunehmende Nachfrage nach flexiblen Anordnungen besteht. Die Herstellung derartiger Anordnungen erfolgt beispielsweise durch Druckverfahren, wie Hochdruck, Tiefdruck, Siebdruck, Flachdruck oder auch so genanntes "non impact printing", wie etwa Thermotransferdruck, Tintenstrahldruck oder Digitaldruck. Vielfach werden aber auch Vakuumverfahren, wie z.B. Chemical Vapor Deposition (CVD), Physical Vapor Deposition (PVD), plasmaunterstützte chemische oder physikalische Depositionsverfahren (PECVD), Sputtern, (Plasma-)Ätzen oder Bedampfung, verwendet, wobei die Strukturierung in der Regel durch Masken erfolgt.

Als Beispiele für bereits kommerzielle oder in ihrem Marktpotential interessante (opto-) elektronische Anwendungen seien hier elektrophoretische oder elektrochrome Aufbauten oder Displays, organische oder polymere Leuchtdioden (OLEDs oder PLEDs) in Anzeigeund Display-Vorrichtungen oder als Beleuchtung genannt, Elektrolumineszenzlampen, lichtemittierende elektrochemische Zellen (LLEDs), organische Solarzellen, bevorzugt Farbstoff- oder Polymersolarzellen, anorganische Solarzellen, bevorzugt Dünnschichtsolarzellen, insbesondere auf der Basis von Silizium, Germanium, Kupfer, Indium und Selen , organische Feldeffekt-Transistoren, organische Schaltelemente, organische optische Verstärker, organische Laserdioden, organische oder anorganische Sensoren oder auch organisch- oder anorganisch basierte RFID-Transponder angeführt.

Als technische Herausforderung für die Realisierung einer ausreichenden Lebensdauer und Funktion von (opto-) elektronischen Anordnungen im Bereich der anorganischen und/oder organischen (Opto-) Elektronik, ganz besonders im Bereich der organischen (Opto-) Elektronik ist ein Schutz der darin enthaltenen Komponenten vor Permeanten zu sehen. Permeanten können eine Vielzahl von niedermolekularen organischen oder anorganischen Verbindungen sein, insbesondere Wasserdampf und Sauerstoff.

Eine Vielzahl von (opto-) elektronischen Anordnungen im Bereich der anorganischen und/oder organischen (Opto-) Elektronik, ganz besonders bei Verwendung von organischen Rohstoffen, ist sowohl gegen Wasserdampf als auch gegen Sauerstoff empfindlich, wobei für viele Anordnungen das Eindringen von Wasserdampf als größeres Problem eingestuft wird. Während der Lebensdauer der elektronischen Anordnung ist deshalb ein Schutz durch eine Verkapselung erforderlich, da andernfalls die Leistung über den Anwendungszeitraum nachlässt. So kann sich beispielsweise durch eine Oxidation der Bestandteile etwa bei lichtemittierenden Anordnungen wie Elektrolumineszenz-Lampen (EL-Lampen) oder organischen Leuchtdioden (OLED) die Leuchtkraft, bei elektrophoretischen Displays (EP-Displays) der Kontrast oder bei Solarzellen die Effizienz innerhalb kürzester Zeit drastisch verringern.

Bei der anorganischen und/oder organischen (Opto-) Elektronik, insbesondere bei der organischen (Opto-) Elektronik, gibt es besonderen Bedarf für flexible Klebelösungen, die eine Permeationsbarriere für Permeanten, wie Sauerstoff und/oder Wasserdampf, darstellen. Daneben gibt es eine Vielzahl von weiteren Anforderungen für derartige (opto- ) elektronische Anordnungen. Die flexiblen Klebelösungen sollen daher nicht nur eine gute Haftung zwischen zwei Substraten erzielen, sondern zusätzlich Eigenschaften wie hohe Scherfestigkeit und Schälfestigkeit, chemische Beständigkeit, Alterungsbeständigkeit, hohe Transparenz, einfache Prozessierbarkeit sowie hohe Flexibilität und Biegsamkeit erfüllen.

Ein nach dem Stand der Technik gängiger Ansatz ist deshalb, die elektronische Anordnung zwischen zwei für Wasserdampf und Sauerstoff undurchlässige Substrate zu legen. Anschließend erfolgt dann eine Versiegelung an den Rändern. Für unflexible Aufbauten werden Glas, Metallsubstrate oder Folienverbunde (zum Beispiel Backsheets aus EVA-, Polyester- und Fluorpolymerschichten in Kombination mit starren Substraten wie Glas und/oder Metall) verwendet, die zum Teil eine hohe Permeationsbarriere bieten, aber sehr anfällig für mechanische Belastungen sind. Ferner verursachen diese Substrate eine relativ große Dicke der gesamten Anordnung. Im Falle von Metallsubstraten besteht zudem keine Transparenz. Für flexible Anordnungen hingegen kommen beidseitig Flächensubstrate, wie transparente oder nicht transparente Folien, zum Einsatz, die mehrlagig ausgeführt sein können. Hierbei können sowohl Kombinationen aus verschieden Polymeren, als auch anorganische oder organische Schichten verwendet werden. Der Einsatz solcher Flächensubstrate ermöglicht einen flexiblen, äußert dünnen Aufbau. Dabei sind für die verschiedenen Anwendungen unterschiedlichste Substrate, wie z.B. Folien, Gewebe, Vliese und Papiere oder Kombinationen daraus möglich.

Zur Charakterisierung der Barrierewirkung werden üblicherweise die Sauerstofftransmissionsrate OTR (Oxygen Transmission Rate) sowie die Wasserdampftransmissionsrate WVTR (Water Vapor Transmission Rate) angegeben. Die jeweilige Rate gibt dabei den flächen- und zeitbezogenen Fluss von Sauerstoff bzw. Wasserdampf durch einen Film unter spezifischen Bedingungen von Temperatur und Partialdruck sowie ggf. weiterer Messbedingungen wie relativer Luftfeuchtigkeit an. Je geringer diese Werte sind, desto besser ist das jeweilige Material zur Kapselung geeignet. Die Angabe der Permeation basiert dabei nicht allein auf den Werten für WVTR oder OTR sondern beinhaltet immer auch eine Angabe zur mittleren Weglänge der Permeation, wie z.B. die Dicke des Materials, oder eine Normalisierung auf eine bestimmte Weglänge.

Die Permeabilität P ist ein Maß für die Durchlässigkeit eines Körpers für Gase und/oder Flüssigkeiten. Ein niedriger P-Wert kennzeichnet eine gute Barrierewirkung. Die Permeabilität P ist ein spezifischer Wert für ein definiertes Material und einen definierten Permeanten unter stationären Bedingungen bei bestimmter Permeationsweglänge, Partialdruck und Temperatur. Die Permeabilität P ist das Produkt aus Diffusions-Term D und Löslichkeits-Term S: P = D * S

Der Löslichkeitsterm S beschreibt vorliegend die Affinität der Barriereklebemasse zum Permeanten. Im Fall von Wasserdampf wird beispielsweise ein geringer Wert für S von hydrophoben Materialen erreicht. Der Diffusionsterm D ist ein Maß für die Beweglichkeit des Permeanten im Barrierematerial und ist direkt abhängig von Eigenschaften, wie der Molekülbeweglichkeit oder dem freien Volumen. Oft werden bei stark vernetzten oder hochkristallinen Materialen für D relativ niedrige Werte erreicht. Hochkristalline Materialien sind jedoch in der Regel weniger transparent und eine stärkere Vernetzung führt zu einer geringeren Flexibilität. Die Permeabilität P steigt üblicherweise mit einer Erhöhung der molekularen Beweglichkeit an, etwa auch wenn die Temperatur erhöht oder der Glasübergangspunkt überschritten wird.

Ansätze, um die Barrierewirkung einer Klebemasse zu erhöhen, müssen die beiden Parameter D und S insbesondere im Hinblick auf den Einfluss auf die Durchlässigkeit von Wasserdampf und Sauerstoff berücksichtigen. Zusätzlich zu diesen chemischen Eigenschaften müssen auch Auswirkungen physikalischer Einflüsse auf die Permeabilität bedacht werden, insbesondere die mittlere Permeationsweglänge und Grenzflächeneigenschaften (Auffließverhalten der Klebemasse, Haftung). Die ideale Barriereklebemasse weist geringe D-Werte und S-Werte bei sehr guter Haftung auf dem Substrat auf.

Ein geringer Löslichkeits-Term S ist meist unzureichend, um gute Barriereeigenschaften zu erreichen. Ein klassisches Beispiel dafür sind insbesondere Siloxan-Elastomere. Die Materialien sind äußerst hydrophob (kleiner Löslichkeits-Term), weisen aber durch ihre frei drehbare Si-O Bindung (großer Diffusions-Term) eine vergleichsweise geringe Barrierewirkung gegen Wasserdampf und Sauerstoff auf. Für eine gute Barrierewirkung ist also eine gute Balance zwischen Löslichkeits-Term S und Diffusions-Term D notwendig.

Für die Verkapselung wurden bisher vor allem Flüssigklebstoffe und Adhäsive auf Basis von Epoxiden verwendet (WO98/21287 A1; US 4,051,195 A; US 4,552,604 A). Diese weisen durch eine starke Vernetzung eine geringe Permeabilität auf. Ihr Haupteinsatzgebiet sind Randverklebungen starrer Anordnungen, aber auch mäßig flexible Anordnungen. Eine Aushärtung erfolgt thermisch oder mittels UV-Strahlung. Eine vollflächige Verklebung ist aufgrund des durch die Aushärtung auftreten Schrumpfes kaum möglich, da es beim Aushärten zu Spannungen zwischen Kleber und Substrat kommt, die wiederum zur Delaminierung führen können.

Der Einsatz dieser flüssigen Klebstoffe birgt eine Reihe von Nachteilen. So können niedermolekulare Bestandteile (VOC - volatile organic compound) die empfindlichen elektronischen Strukturen der Anordnung schädigen und den Umgang in der Produktion erschweren. Der Klebstoff muss aufwendig auf jeden einzelnen Bestandteil der Anordnung aufgebracht werden. Die Anschaffung von teuren Dispensern und Fixiereinrichtungen ist notwendig, um eine genaue Positionierung zu gewährleisten. Die Art der Auftragung verhindert zudem einen schnellen kontinuierlichen Prozess und auch durch den anschließend erforderlichen Laminationsschritt kann durch die geringe Viskosität das Erreichen einer definierten Schichtdicke und Verklebungsbreite in engen Grenzen erschwert sein.

Des Weiteren weisen solche hochvernetzten Klebstoffe nach dem Aushärten nur noch eine geringe Flexibilität auf. Der Einsatz von thermisch-vernetzenden Systemen wird im niedrigen Temperaturbereich oder bei 2-Komponenten-Systemen durch die Topfzeit begrenzt, also die Verarbeitungszeit bis eine Vergelung stattgefunden hat. Im hohen Temperaturbereich und insbesondere bei langen Reaktionszeiten begrenzen wiederum die empfindlichen (opto-) elektronischen Strukturen die Verwendbarkeit derartiger Systeme - die maximal anwendbaren Temperaturen bei (opto-) elektronischen Strukturen liegen oft bei 60°C, da bereits ab dieser Temperatur eine Vorschädigung eintreten kann. Insbesondere flexible Anordnungen, die organische Elektronik enthalten und mit transparenten Polymerfolien oder Verbunden aus Polymerfolien und anorganischen Schichten gekapselt sind, setzen hier enge Grenzen. Dies gilt auch für Laminierschritte unter großem Druck. Um eine verbesserte Haltbarkeit zu erreichen, ist hier ein Verzicht auf einen temperaturbelastenden Schritt und eine Laminierung unter geringerem Druck von Vorteil.

Alternativ zu den thermisch härtbaren Flüssigklebstoffen werden mittlerweile vielfach auch strahlenhärtende Klebstoffe eingesetzt (US 2004/0225025 A1). Die Verwendung von strahlenhärtenden Klebstoffen vermeidet eine lange andauernde Wärmebelastung der elektronischen Anordnung. Jedoch kommt es durch die Bestrahlung zu einer kurzfristigen punktuellen Erhitzung der Anordnung, da neben einer UV-Strahlung in der Regel auch ein sehr hoher Anteil an IR-Strahlung emittiert wird. Weitere oben genannte Nachteile von Flüssigklebstoffen wie VOC, Schrumpf, Delamination und geringe Flexibilität bleiben ebenfalls erhalten. Probleme können durch zusätzliche flüchtige Bestandteile oder Spaltprodukte aus den Photoinitiatoren oder Sensitizern entstehen. Zudem muss die Anordnung durchlässig für UV-Licht sein.

Da Bestandteile insbesondere organischer Elektronik und viele der eingesetzten Polymere häufig empfindlich gegen UV-Belastung sind, ist ein länger andauernder Außeneinsatz nicht ohne weitere zusätzliche Schutzmaßnahmen, etwa weitere Deckfolien möglich. Diese können bei UV-härtenden Klebesystemen erst nach der UV-Härtung aufgebracht werden, was die Komplexität der Fertigung und die Dicke der Anordnung zusätzlich erhöht.

Die US 2006/0100299 A1 offenbart ein UV-härtbares Haftklebeband zur Kapselung einer elektronischen Anordnung. Das Haftklebeband umfasst eine Klebemasse auf Basis einer Kombination eines Polymers mit einem Erweichungspunkt von größer 60°C, eines polymerisierbaren Epoxidharzes mit einem Erweichungspunkt von unter 30°C und einem Photoinitiator. Bei den Polymeren kann es sich um Polyurethan, Polyisobutylen, Polyacrylnitril, Polyvinylidenchlorid, Poly(meth)acrylat oder Polyester, insbesondere aber um ein Acrylat handeln. Zur Erreichung einer ausreichenden Scherfestigkeit erfolgt eine UV-Vernetzung.

Acrylatmassen haben eine sehr gute Beständigkeit gegenüber UV-Strahlung und verschiedenen Chemikalien, besitzen aber sehr unterschiedliche Klebkräfte auf verschiedenen Untergründen. Während die Klebkraft auf polaren Untergründen wie Glas oder Metall sehr hoch ist, ist die Klebkraft auf unpolaren Untergründen wie beispielsweise Polyethylen oder Polypropylen eher gering. Hier besteht die Gefahr der Diffusion an der Grenzfläche in besonderem Maße. Zudem sind diese Massen sehr polar, was eine Diffusion insbesondere von Wasserdampf, trotz nachträglicher Vernetzung, begünstigt. Durch den Einsatz polymerisierbarer Epoxidharze wird diese Tendenz weiter verstärkt.

Die in US 2006/0100299 A1 genannte Ausführung als Haftklebemasse hat den Vorteil einer einfachen Applikation, leidet aber ebenfalls unter möglichen Spaltprodukten durch die enthaltenen Photoinitiatoren, einer zwangsläufigen UV-Durchlässigkeit des Aufbaus und einer Verringerung der Flexibilität nach der Aushärtung. Zudem ist durch den geringen Anteil an Epoxidharzen oder anderen Vernetzern, der für eine Erhaltung der Haftklebrigkeit und insbesondere der Kohäsion notwendig ist, eine nur sehr viel geringere Vernetzungsdichte als mit Flüssigklebern erreichbar.

Die WO 2007/087281 A1 offenbart ein transparentes flexibles Haftklebeband auf Basis von Polyisobutylen (PIB) für elektronische Anwendungen, insbesondere OLED. Dabei wird Polyisobutylen mit einem Molekulargewicht von mehr als 500.000 g/mol und ein hydriertes cyclisches Harz verwendet. Optional ist der Einsatz eines photopolymerisierbaren Harzes und eines Photoinitiators möglich. Klebemassen auf der Basis von Polyisobutylen weisen aufgrund ihrer geringen Polarität eine gute Barriere gegen Wasserdampf auf, haben aber selbst bei hohen Molekulargewichten eine relativ geringe Kohäsivität, weshalb schon bei Raumtemperatur und insbesondere bei erhöhten Temperaturen, unter Belastung eine Kriechneigung festgestellt werden kann und sie deshalb eine geringe Scherfestigkeit aufweisen. Der Anteil an niedermolekularen Bestandteilen kann nicht beliebig reduziert werden, da sonst die Haftung deutlich verringert wird und die Grenzflächenpermeation zunimmt. Bei Einsatz eines hohen Anteils an funktionellen Harzen, der aufgrund der sehr geringen Kohäsion der Masse notwendig ist, wird die Polarität der Masse wieder erhöht und damit der Löslichkeits-Term vergrößert.

Demgegenüber zeigt eine Haftklebemasse mit ausgeprägter Vernetzung zur Reduzierung der Kriechneigung zwar gute Kohäsion, doch ist das Auffließverhalten beeinträchtigt. Die Haftklebemasse kann sich nur unzureichend an die Rauhigkeit einer Substratoberfläche anpassen, wodurch die Permeation an der Grenzfläche erhöht ist. Zudem kann eine Haftklebemasse mit ausgeprägter Vernetzung nur in geringerem Maße Verformungsenergie, wie sie unter Belastung auftritt, dissipieren. Durch beide Phänomene wird die Klebkraft reduziert. Eine geringfügig vernetzte Haftklebemasse kann dagegen zwar gut auf raue Oberflächen auffließen und Verformungsenergie dissipieren, so dass die Anforderungen an die Adhäsion erfüllt sein können, jedoch widersteht die Haftklebemasse auf Grund einer reduzierten Kohäsion nur unzureichend einer Belastung.

Aus dem Stand der Technik ist zudem eine nicht näher beschriebene Haftklebemasse ohne Barriereeigenschaften bekannt (WO 03/065470 A1), die in einem elektronischen Aufbau als Transferklebemasse verwendet wird. Die Klebemasse enthält einen funktionellen Füllstoff, der mit Sauerstoff oder Wasserdampf innerhalb des Aufbaus reagiert. Damit ist eine einfache Applikation eines Scavengers innerhalb des Aufbaus möglich. Für die Versiegelung des Aufbaus nach Außen wird ein weiteres Adhäsiv mit geringer Durchlässigkeit verwendet.

Bekannt ist die Verwendung von polyolefinischen Heißschmelzklebern, wie sie im Verpackungsbereich üblich sind z.B. Kartonverschlussheißschmelzkleber und Siegelschichten in Folienverpackungen, die im wesentlichen auf sich selbst verkleben, auch in (opto-) elektronischen Aufbauten. Diese haben jedoch den Nachteil, dass sie für die Verklebung erhitzt werden müssen, was die Gefahr der Schädigung des elektronischen Aufbaus birgt.

WO 2008/036707 A2 offenbart eine optoelektronische Anordnung die mit Heißschmelzklebern verkapselt ist.

EP 1 955 844 A1 offenbart auch eine optoelektronische Anordnung die mit Heißschmelzklebern verkapselt ist.

Haftklebstoffe benötigen in der Regel durch die relativ hochmolekularen Polymere im Gegensatz zu Flüssig- und Heißschmelzklebstoffen für eine gute Benetzung und Haftung auf der Oberfläche eine gewisse Zeit, ausreichenden Druck und eine gute Balance zwischen viskosem Anteil und elastischen Anteil. Allgemein führt das nachträgliche Vernetzen der Klebemassen zu einem Schrumpf der Masse. Dies kann zu einer Verringerung der Haftung an der Grenzfläche führen und wiederum die Permeabilität erhöhen.

Um eine möglichst gute Versiegelung und einfache Handhabung zu erzielen besteht das Bedürfnis nach einer Klebemasse mit Barriereeigenschaften und Vermeidung der geschilderten Nachteile der Lösungsansätze auf Basis von Haftklebern. Eine gute Klebemasse für die Versiegelung von (opto-) elektronischen Bauteilen soll eine geringe Permeabilität gegen Sauerstoff und insbesondere gegen Wasserdampf, ausreichende Haftung auf der Anordnung und gutes Auffließen aufweisen. Eine geringe Haftung auf der Anordnung verringert die Barrierewirkung an der Grenzfläche, wodurch ein Eintritt von Sauerstoff und Wasserdampf unabhängig von den Eigenschaften der Klebmasse ermöglicht wird. Nur wenn der Kontakt zwischen Masse und Substrat durchgängig ist, sind die Masseeigenschaften der bestimmende Faktor für die Barrierewirkung der Klebemasse. Selbst wenn der Klebebandträger gute Barriereeigenschaften aufweist, ist die Permeation durch die Klebemasse eine Schwachstelle. Dies ist ein Schwachpunkt der bisherigen Bemühungen Haftkleber auf Basis von Acrylat, Polyurethan oder Silikon für solche Anwendungen einzusetzen. Daher ist es wünschenswert die Querschnittsfläche des Haftklebers gegenüber der Atmosphäre möglichst gering zu halten, das heißt die Schichtdicke (Masseauftrag) soll niedrig sein. Um trotzdem ausreichende Haftung zu erzielen, sollte der Haftkleber die Eigenschaft aufweisen trotz geringem Masseauftrag gut zu haften.

Aufgabe der vorliegenden Erfindung ist es, ein Verfahren zur Kapselung einer elektronischen Anordnung gegen Permeanten, insbesondere Wasserdampf und Sauerstoff, anzugeben, das einfach durchführbar ist und mit dem gleichzeitig eine gute Kapselung erzielt wird. Dadurch soll die Lebensdauer von (opto-) elektronischen Anordnungen durch die Verwendung einer geeigneten, insbesondere flexiblen, Klebemasse erhöht werden.

Die vorliegende Erfindung löst das zuvor beschriebene Problem durch ein Verfahren gemäß Anspruch 1. Nebengeordnete Lösungen beschreiben die Patentansprüche 6 und 16. Bevorzugte Ausgestaltungen und Weiterbildungen sind Gegenstand der jeweiligen Unteransprüche.

Die vorliegende Erfindung beruht zunächst auf der Erkenntnis, dass es trotz der zuvor beschriebenen Nachteile möglich ist, eine Haftklebemasse zur Kapselung einer elektronischen Anordnung zu verwenden, bei der die zuvor bzgl. Haftklebemassen beschriebenen Nachteile nicht oder nur vermindert auftreten. Es hat sich gezeigt, dass eine Haftklebemasse auf Basis von speziellen Polyolefinen zur Kapselung elektronischer Anordnungen besonders geeignet ist. Auf Basis von Polyolefinen in diesem Sinne bedeutet, dass überwiegend das Polyolefin die Funktion der Elastomerkomponente übernimmt. Vorzugsweise ist Polyolefin alleinig als Elastomerkomponente vorgesehen oder jedenfalls aber zu mindestens 50 Gew.-% bezogen auf den Gesamtanteil aller Elastomerkomponenten.

Bei den speziellen Polyolefinen handelt es sich um solche, die eine Dichte zwischen 0,86 und 0,89 g/cm³ aufweisen sowie einen Kristallitschmelzpunkt von mindestens 90°C. Durch die untere Grenze der Dichte werden die Polyolefine definiert, die eine hinreichende Kristallstruktur aufweisen. Sofern der kristalline Anteil jedoch zu groß ist, werden die Polyolefine hart und sind nicht mehr zum Einsatz in einer Klebemasse geeignet. Diese Grenze wird durch die maximale Dichte angegeben. Insbesondere werden derartige Polyolefine mit einem Klebharz kombiniert. Die resultierende Haftklebemasse ist vorzugsweise bei 23°C haftklebrig. Teilkristalline Polyolefine werden bisher nicht für Haftklebeanwendungen eingesetzt, da es dem Fachmann unmöglich erschien, diesen haftklebrige Eigenschaften zu verleihen. Nachdem es gelungen ist, dieses zu erreichen, war es umso überraschender, dass sich gerade dieser neue Typ von Haftklebemasse für Verkapselungsanwendungen als besonders geeignet erwiesen hat.

Übliche teilkristalline Polyolefine, wie sie für thermoplastische Verarbeitung bekannt sind, zum Beispiel Polyethylen oder Polypropylen oder deren Copolymere mit leicht verringerter Kristallinität und Biegemodul, weisen auch durch Zusatz von Klebharzen keinerlei Haftklebrigkeit auf.

Spezielle weiche Polyolefine mit geringer oder völlig fehlender Kristallinität wie Butyl- oder EPDM-Kautschuk sind auch nicht haftklebrig d.h. sie weisen keine signifikante Klebkraft auf. Sehr glatte Schichten aus solchen weichen Polyolefinen können auf sehr glatten Untergründen wie Glas oder Kunststoffgläsern leicht haften, sie verhalten sich wie ebenso glatte Schichten aus Naturkautschuk, Butylkautschuk oder hochweichgemachtem PVC. Solche Materialien können ihr Eigengewicht halten so dass sie nicht von selbst abfallen, weisen aber bei Schälbelastung jedoch praktisch keinen Widerstand auf, weil ihre Glastemperatur verglichen mit einem Haftkleber viel zu niedrig ist. Darüber hinaus neigen solche Materialien bei Lagerung zum Zusammenfließen, weil keine ausreichende Kristallinität vorliegt oder sie werden schon als Block (Ballen) geliefert. Auch in Form eines Haftklebers weisen diese einen kalten Fluss auf, der durch den Zusatz von Klebharz mit dem Ziel die Klebkraft zu erhöhen noch weiter verstärkt wird.

Randomcopolymere mit hohem Comonomeranteil, auch Plastomere genannt, werden als Flexibilisierungsmittel für harte Polyolefine angeboten, sind weich, wenig kristallin und daher prinzipiell klebrig einzustellen, weisen jedoch einen Kristallitschmelzpunkt je nach Type zwischen 40°C und 60 °C auf und können daher keine wärmescherfesten Haftkleber ergeben. Darüber hinaus wurde gefunden, dass bei Verwendung eines Klebharzes der Kristallitschmelzpeak (bestimmt mit der Differential Scanning Calorimetry (DSC)) von Polyolefinplastomeren, welche einen Schmelzpunkt von deutlich unter 100 °C aufweisen, in einer Kleberformulierung mit Klebharz und optional einem Weichmacher verloren geht, das heißt, selbst bei Raumtemperatur ist keine Scherfestigkeit wegen fehlender Netzwerkbildung durch kristalline Bereiche gegeben. Solche weichen Plastomere sind daher nur für harzfreie oder zumindest harzarme und weichmacherfreie Oberflächenschutzfolien geeignet, bei denen keine Anforderung an eine signifikante Klebkraft (das heißt über 0,1 N/cm) und Wärmebeständigkeit gegeben ist.

Die erfindungsgemäße Klebemasse, wie nachfolgend beschrieben, wird auf Basis eines speziellen Polyolefins bereitgestellt und auf die zu kapselnden Bereiche der elektronischen Anordnung appliziert. Da es sich bei der Klebemasse um eine Haftklebemasse handelt, ist die Applikation besonders einfach, da keine Vorfixierung oder dgl. erfolgen muss. Je nach Ausgestaltung der Haftklebemasse ist auch keine nachfolgende Behandlung mehr erforderlich. Auch kann durch die Darreichung als Haftklebeband die zu applizierende Menge der Haftklebemasse einfach dosiert und automatisch appliziert werden. Zudem fallen bei der Verwendung einer polyolefinbasierten Haftklebemasse keine Lösemittelemissionen an, falls diese aus der Schmelze beschichtet wird.

Die Haftklebemasse, welche erfindungsgemäß für Verkapselungsverfahren von elektronischen Anordnungen verwendet wird, enthält ein teilkristallines Polyolefin mit einer Dichte zwischen 0,86 und 0,89 g/cm³, vorzugsweise zwischen 0,86 und 0,88 g/cm³, besonders bevorzugt zwischen 0,86 und 0,87 g/cm³. Der Kristallitschmelzpunkt beträgt mindestens 90°C, vorzugsweise mindestens 115°C, besonders bevorzugt mindestens 135°C. Zudem ist in ein Klebharz in der Haftklebemasse enthalten. Klebharze sind Additive mit höherer Glastemperatur, als das klebrig zu machende Polymer, zur Erhöhung der Klebkraft des reinen Polymers. Bevorzugt werden Verkapselungsverfahren von optoelektronischen Anordnungen.

Haftklebemassen im Sinne dieser Erfindung schließen auch Massen ein, welche zwar bei Raumtemperatur nicht haftklebrig sind, aber diese Eigenschaften oberhalb Raumtemperatur aber unterhalb von 100°C, insbesondere unterhalb von 70°C aufweisen. Derartige Massen werden bevorzugt, wenn die Scherfestigkeit bei erhöhten Gebrauchstemperaturen von vorrangiger Bedeutung ist. Sie werden daher bei erhöhter Temperatur aufgeklebt, die jedoch wegen einer potentiellen Schädigung der Anordnung nicht über 100°C liegt. Bevorzugt werden Massen, welche bei 23 °C haftklebrig sind, so dass die Applikation ohne Wärmeeinwirkung einfacher erfolgen kann, wodurch auch eine thermische Schädigung der elektronischen Anordnung ausgeschlossen ist.

Im Bereich der Klebstoffe zeichnen sich Haftklebemassen insbesondere durch ihre permanente Klebrigkeit und Flexibilität aus. Ein Material, das permanente Haftklebrigkeit aufweist, muss zu jedem Zeitpunkt eine geeignete Kombination aus adhäsiven und kohäsiven Eigenschaften aufweisen. Diese Charakteristik unterscheidet die Haftklebemassen beispielsweise von reaktiven Klebstoffen, die im nicht ausreagierten Zustand kaum Kohäsion bieten. Für gute Haftungseigenschaften gilt es, Haftklebemassen so einzustellen, dass eine optimale Balance aus adhäsiven und kohäsiven Eigenschaften besteht.

Als Kapselung wird vorliegend nicht nur ein vollumfänglicher Einschluss mit der genannten Haftklebemasse bezeichnet sondern auch bereits eine bereichsweise Applikation der Haftklebemasse auf den zu kapselnden Bereichen der (opto- ) elektronischen Anordnung, beispielsweise eine einseitige Überdeckung oder eine Umrahmung einer elektronischen Struktur.

Durch die Auswahl der Bestandteile der Haftklebemasse und die dadurch sehr geringe Polarität resultierend aus einem im folgenden beschriebenen unpolaren Polyolefin in Kombination mit unpolaren Klebharzen, die eine hohe Erweichungstemperatur aufweisen, wird ein niedriges Durchtrittsvermögen von Permeanten wie Wasserdampf und Sauerstoff erreicht, insbesondere aber von Wasserdampf. Im Vergleich zu reinen Polyolefinfolien und anderen Haftklebemassen wird in besonders vorteilhaften Ausführungsformen zusätzlich eine weitere Verringerung der Sauerstoffpermeabilität erreicht.

Durch weitere Komponenten, wie nachfolgend beschrieben, können je nach Anforderungen der (opto-) elektronischen Anordnung, etwa durch eine Vernetzungsreaktion, die Eigenschaften vorteilhaft an die Anforderungen angepasst werden.

Vorteil der hier vorliegenden Erfindung ist also, im Vergleich zu anderen Haftklebemassen, die Kombination aus guten Barriereeigenschaften gegenüber Sauerstoff und vor allem gegenüber Wasserdampf bei gleichzeitiger guter Grenzflächenhaftung auf unterschiedlichen Substraten, insbesondere auf unpolaren Substraten (die sogenannte Low-Surface-Energy- (LSE) Oberflächen aufweisen), guten kohäsiven Eigenschaften durch die Netzwerkbildung der Kristallite und, im Vergleich zu Flüssigklebstoffen, einer höheren Flexibilität und einer einfachen Applikation in der (opto) elektronischen Anordnung und bei/in der Kapselung. Je nach Ausführung der Haftklebemasse bieten Klebemassen auf Basis von Polyolefinen eine gute Beständigkeit gegenüber Chemikalien und Umwelteinflüssen wie Wärme, Feuchtigkeit oder Licht. Des Weiteren liegen in bestimmten Ausführungen auch transparente Klebemassen vor, die in besonderer Weise für den Einsatz in (opto-) elektronischen Anordnungen Anwendung finden können, da eine Verminderung von einfallendem oder austretendem Licht sehr gering gehalten wird.

Die Haftklebemasse auf Basis der beschriebenen teilkristallinen Polyolefine zeichnet sich also, neben guter Verarbeitbarkeit und Beschichtbarkeit, durch gute Produkteigenschaften in Bezug auf Adhäsion und Kohäsion aus sowie durch eine gute Barrierewirkung gegenüber Sauerstoff und eine sehr gute Barrierewirkung gegenüber Wasserdampf, insbesondere im Vergleich zu Haftklebemassen auf Basis von Acrylaten, Silikonen, Ethylen-Vinyl-Acatat, und bestimmten Ausführungsformen von Styrolblockcopolymeren (Vinylaromatenblockcopolymeren aus Styrol und 1,3-Dienen).

Eine derartige Haftklebemasse kann auf einfache Weise in eine elektronische Anordnung integriert werden, insbesondere auch in solche Anordnung, die hohe Flexibilität erfordert. Weitere besonders vorteilhafte Eigenschaften der Haftklebemasse sind ähnlich gute Haftung auf unterschiedlichen Substraten, insbesondere auf niedrigenergetischen Oberflächen, hohe Scherfestigkeit und hohe Flexibilität. Durch eine sehr gute Haftung am Substrat wird zudem auch eine geringe Grenzflächenpermeation erzielt.

Bei der Verklebung niederenergetischer Oberflächen werden üblicherweise Klebemassen auf Basis von Naturkautschuk, Styrolblockcopolymer und/oder Acrylat verwendet. Die Naturkautschuk-Klebemassen sind oft lösungsmittelhaltig und weisen eine geringe Alterungs- und UV-Stabilität auf. Styrolblockcopolymer-Klebemassen, in der Regel basierend auf einer Styrol-Isopren-Styrol-Blockcopolymeren, sind lösungsmittelfrei verarbeitbar, weisen aber ebenfalls eine geringe Alterungs- und UV-Stabilität auf. Beide Sorten von Kautschukmassen weisen auf niederenergetischen Oberflächen gute Haftung auf. Klebemassen auf Basis hydrierter Styrolblockcopolymere sind sehr teuer, haben aber vergleichsweise geringen Tack und Klebkraft. Sie erweichen ebenfalls schon deutlich unter 100°C. Acrylat-Klebemassen haben eine gute Alterungs- und UV-Stabilität, haften aber auf niederenergetischen unpolaren Polymeren, wie zum Beispiel Polyolefinen, trotz aller bisherigen Bemühungen nur schlecht, weshalb die zu verklebenden Oberflächen mit lösungsmittelhaltigen Primern vorbehandelt werden müssen. Silikonhaftkleber haben eine gute Alterungs- und UV-Stabilität und gute Haftung auf niederenergetischen Oberflächen, sind aber extrem teuer und lassen sich nicht mit den üblichen silikonisierten Linern abdecken (bzw. sich davon nicht wieder abziehen). Durch die Verwendung der hier beschriebenen Formulierungen für die Verkapselung von (opto-) elektronischen Strukturen werden vorteilhafte Anordnungen gewonnen, die die oben genannten Vorteile vereinen und den Verkapselungsprozess dadurch beschleunigen und vereinfachen.

Da in bestimmten Ausführungen der Haftklebemasse keine thermischen Prozessschritte oder Bestrahlung notwendig sind, kein Schrumpf durch eine Vernetzungsreaktion auftritt und die Haftklebemasse als bahnförmiges Material oder in einer der elektronischen Anordnung entsprechend angepassten Form vorliegt, kann die Masse einfach und schnell unter geringem Druck in den Verkapselungsprozess des (opto-) elektronischen Aufbaus integriert werden. Die üblicherweise mit den verschiedenen Verarbeitungsschritten einhergehenden Nachteile, wie thermische und mechanische Belastungen, können so minimiert werden. Eine Verkapselung durch Lamination von zumindest Teilen der (opto-) elektronischen Aufbauten mit einem flächigen Barrierematerial (z.B. Glas, insbesondere Dünnglas, metalloxidbeschichteten Folien, Metallfolien, Multilayer-Substratmaterialien) ist mit sehr guter Barrierewirkung in einem einfachen Rolle-zu-Rolle Prozess möglich. Die Flexibilität des gesamten Aufbaus hängt, neben der Flexibilität der Haftklebemasse von weiteren Faktoren, wie Geometrie und Dicke der (opto-)elektronischen Aufbauten bzw. der flächigen Barrierematerialien ab. Die hohe Flexibilität der Haftklebemasse ermöglicht es aber sehr dünne, biegsame und flexible (opto-) elektronische Aufbauten zu realisieren. Unter dem benutzten Begriff "biegsam" ist die Eigenschaft zu verstehen, dass der Krümmung eines gebogenen Gegenstands wie einer Trommel mit bestimmtem Radius, insbesondere mit einem Radius von 5 mm, ohne Beschädigung gefolgt wird.

Von besonderem Vorteil für die Kapselung von (opto-) elektronischen Aufbauten ist es, wenn diese vor, während oder nach der Applikation der Haftklebemasse erwärmt werden. Dadurch kann die Haftklebemasse besser auffließen und somit die Permeation an der Grenzfläche zwischen der (opto-) elektronischen Anordnung und der Haftklebemasse vermindert werden. Die Temperatur sollte dabei bevorzugt mehr als 30°C, weiter bevorzugt mehr als 50°C betragen, um das Auffließen entsprechend zu fördern. Zu hoch sollte die Temperatur jedoch nicht gewählt werden, um die (opto-) elektronische Anordnung nicht zu beschädigen. Die Temperatur sollte möglichst weniger als 100°C betragen. Als optimaler Temperaturbereich haben sich Temperaturen zwischen 50°C und 70°C herausgestellt. Vorteilhaft ist es ebenso, wenn die Haftklebemasse vor, während oder nach der Applikation zusätzlich oder alternativ erwärmt wird.

In bevorzugter Ausgestaltung eines Verfahrens zur Kapselung einer elektronischen Anordnung gegen Permeanten kann die Haftklebemasse als Bestandteil eines Klebebandes bereitgestellt werden. Diese Darreichungsart erlaubt eine besonders einfache und gleichmäßige Applikation der Haftklebemasse.

Der allgemeine Ausdruck "Klebeband" umfasst dabei in einer Ausführungsform ein Trägermaterial, welches ein- oder beidseitig mit einer Haftklebemasse versehen ist. Die Klebemasse kann auch mehrschichtig aufgebracht werden. Bei mehrschichtigem Aufbau können mehrere Schichten durch Coextrusion, Kaschierung oder Beschichtung übereinander gebracht werden. Das Trägermaterial umfasst alle flächigen Gebilde, beispielsweise in zwei Dimensionen ausgedehnte Folien oder Folienabschnitte, Bänder mit ausgedehnter Länge und begrenzter Breite, Bandabschnitte, Stanzlinge, Mehrschichtanordnungen und dergleichen. Dabei sind für verschiedene Anwendungen unterschiedlichste Träger, wie z.B. Kunststoff- und Metallfolien, Gewebe, Vliese und Papiere mit den Klebmassen kombinierbar.

Des Weiteren umfasst der Ausdruck "Klebeband" auch so genannte "Transferklebebänder", d.h. ein Klebeband ohne Träger. Bei einem Transferklebeband ist die Klebemasse vielmehr vor der Applikation zwischen (flexiblen) Linern aufgebracht die mit einer Trennschicht mit anti-adhäsiven Eigenschaften versehen ist. Zur Applikation wird regelmäßig zunächst ein Liner entfernt, die Klebemasse appliziert und dann ein optional zweiter Liner entfernt. Die Haftklebemasse kann so direkt zur Verbindung zweier Oberflächen in (opto-) elektronischen Anordnungen verwendet werden.

Der Begriff "Klebeband" umfasst nicht nur Klebeband in Rollenform, sondern auch als Abschnitte oder Stanzlinge, letztere werden gemeinhin auch als Etiketten bezeichnet.

Als Trägermaterial eines Klebebandes werden vorliegend bevorzugt Polymerfolien, Folienverbunde oder mit organischen und/oder anorganischen Schichten versehene Folien oder Folienverbunde eingesetzt. Derartige Folien / Folienverbunde können aus allen gängigen zur Folienherstellung verwendeten Kunststoffen, Gläsern oder Metallen bestehen, beispielhaft aber nicht einschränkend erwähnt seien:
Polyethylen, Polypropylen, Cyclische Olefin Copolymere (COC), Polyvinylchlorid (PVC), Polyester - insbesondere Polyethylenterephthalat (PET) und Poylethylennaphtalat (PEN), Ethylenvinylalkohol (EVOH), Polyvinylidenchlorid (PVDC), Polyvinylidenfluorid (PVDF), Polyacrylnitril (PAN), Polycarbonat (PC), Polyamid (PA), Polyethersulfon (PES), Polyimid (PI) oder auch Metallfolien wie Aluminiumfolie..

Der Träger kann zudem mit organischen oder anorganischen Beschichtungen oder Schichten kombiniert sein. Dies kann durch übliche Verfahren, wie z.B. Lackieren, Drucken, Bedampfen, Sputtern, Co-Extrusion oder Lamination geschehen. Beispielhaft, aber nicht einschränkend erwähnt seien hier etwa Metalle, Oxide oder Nitride des Siliziums und des Aluminiums, Indium-Zinn-Oxid (ITO) oder Metallorganische Verbindungen, wie sie etwa bei Sol-Gel-Beschichtungen Einsatz finden.

Besonders bevorzugt sind diese Folien / Folienverbunde, insbesondere die Polymerfolien, mit einer Permeationsbarriere für Sauerstoff und Wasserdampf versehen, wobei die Permeationsbarriere die Anforderungen für den Verpackungsbereich übertrifft (WVTR < 10⁻¹ g/(m²d); OTR < 10⁻¹ cm³/(m²d bar)). Die Bestimmung der Permeabilität für Sauerstoff (OTR) und Wasserdampf (WVTR) erfolgt nach DIN 53380 Teil 3 bzw. ASTM F-1249. Die Sauerstoffdurchlässigkeit wird bei 23°C und einer relativen Feuchte von 50% gemessen. Die Wasserdampfdurchlässigkeit wird bei 37,5°C und einer relativen Feuchte von 90% bestimmt. Die Ergebnisse werden auf eine Foliendicke von 50 µm normiert.

Je nach Anforderungen der (opto-) elektronischen Anordnung können in einer bestimmten Ausführung der Haftklebemasse die elastischen und viskosen Eigenschaften, sowie die Barrierewirkung durch eine (nachträgliche) Vernetzungsreaktion variiert werden. Dies kann angepasst an die (opto-) elektronische Anordnung sowohl thermisch, als auch durch elektromagnetische Strahlung, bevorzugt UV-Strahlung, Elektronenstrahlung oder Gammastrahlung stattfinden. Dabei sollte die hohe Flexibilität der Haftklebemasse erhalten bleiben. Weiter bevorzugt erfolgt die Vernetzung, sofern erforderlich, vor der Applikation der Haftklebemasse auf der elektronischen Anordnung. Eine für die Vernetzung ggf. erforderliche Energiezufuhr, beispielsweise in Form von Wärme oder durch UV-Bestrahlung oder dgl., kann so die elektronischen Strukturen nicht beeinträchtigen.

Weiter bevorzugt kommt eine Haftklebemasse zum Einsatz, die in bestimmten Ausführungen im sichtbaren Licht des Spektrums (Wellenlängenbereich von etwa 400 nm - 800 nm) transparent ist. "Transparenz" bedeutet dabei eine mittlere Transmission der Klebemasse im sichtbaren Bereich des Lichts von mindestens 75 %, bevorzugt höher als 90 %. Bei der Ausführung als Haftklebeband mit Träger hängt die maximale Transmission des gesamten Aufbaus zudem von der Art des verwendeten Trägers und der Art des Aufbaus ab. Die gewünschte Transparenz lässt sich insbesondere durch die Verwendung farbloser Klebharze erzielen.

Die Transmission der Klebemasse wurde über das VIS-Spektrum bestimmt. Die Aufnahmen des VIS-Spektrums wurden an einem UVIKON 923 der Firma Kontron durchgeführt. Der Wellenlängenbereich des gemessenen Spektrums umfasst alle Frequenzen zwischen 400 nm und 800 nm bei einer Auflösung von 1 nm. Dazu wurde die Klebemasse auf einen PET-Träger aufgebracht und vor der Messung wurde eine Leerkanalmessung des Trägers als Referenz über den gesamten Wellenlängenbereich durchgeführt. Für die Angabe des Ergebnisses wurden die Transmissionsmessungen im angegebenen Bereich gemittelt.

Eine derartige Haftklebemasse eignet sich somit auch für einen vollflächigen Einsatz über einer (opto-) elektronischen Struktur. Eine vollflächige Verklebung bietet, bei einer etwa mittigen Anordnung der elektronischen Struktur gegenüber einer Randversiegelung den Vorteil, dass der Permeant durch gesamte Fläche diffundieren müsste, bevor er die Struktur erreicht. Der Permeationsweg ist somit deutlich erhöht. Die in dieser Ausführungsform verlängerten Permeationswege im Vergleich zur Randversiegelung etwa durch Flüssigklebstoffe wirken sich positiv auf die Gesamtbarriere aus, da der Permeationsweg umgekehrt proportional zur Durchlässigkeit ist.

Die elektronischen Strukturen (opto-) elektronischer Anordnungen sind oftmals anfällig gegenüber UV-Strahlung. Als besonders vorteilhaft hat sich daher herausgestellt, wenn die Haftklebemasse zudem UV-blockend ausgebildet ist. Unter dem Begriff "UV-blockend" wird vorliegend ein mittlerer Transmissionsgrad von maximal 20%, vorzugsweise von maximal 10%, weiter bevorzugt von maximal 1% im entsprechenden Wellenlängenbereich bezeichnet. In bevorzugter Ausgestaltung ist die Haftklebemasse im Wellenlängenbereich von 320 nm bis 400 nm (UVA-Strahlung) UV-blockend ausgebildet, vorzugsweise im Wellenlängenbereich von 280 nm bis 400 nm (UVA- und UVB-Strahlung), weiter vorzugsweise im Wellenlängenbereich von 190 nm bis 400 nm (UVA-, UVB- und UVC-Strahlung).

Die UV-blockende Wirkung der Haftklebemasse kann insbesondere durch eine Zugabe von Lichtschutzmitteln wie UV-Absorbern oder geeigneten Füllstoffen zur Haftklebemasse erzielt werden. Als Lichtschutzmittel eignen sich beispielsweise HALS (Hindert Armine Light Stabilizer), Benzimidazolderivate und weiter Lichtschutzmittel wie sie zum Beispiel unter den Handelsnamen Chimassorb oder Tinuvin der Firma Ciba dem Fachmann bekannt sind.. Als Füllstoff ist wegen der hohen UV-Absorption besonders Titandioxid geeignet, ganz besonders nanoskaliges Titandioxid, welche eine Transparenz auch im sichtbaren Bereich aufweist.

Die beschriebene Haftklebemasse zeigt im Vergleich zu konventionellen Haftklebemassen basierend auf Natur- oder Synthesekautschuken wie Styrol-Dien-Blockcopolymere eine sehr gute Beständigkeit gegen Wärme, Witterungseinflüsse und UV-Licht. Diese Beständigkeit wird insbesondere durch Verwendung von hydrierten Harzen sichergestellt.

Die beschriebene Haftklebemasse, welche für Verkapselungsverfahren von elektronischen Anordnungen verwendet wird, enthält ein teilkristallines Polyolefin mit einer Dichte zwischen 0,86 und 0,89 g/cm³ und weist einen Kristallitschmelzpunkt von mindestens 90°C auf. Wie dem Fachmann geläufig ist, kann (Teil)kristallinität durch DSC festgestellt werden, wenn das Diagramm mindestens einen endothermen Schmelzpeak aufweist. Teilkristalline Polyolefine wie Polyethylen oder Polypropylen galten dem Fachmann bisher für Haftklebemassen aufgrund der Härte und der hohen Kristallisationsneigung als nicht geeignet. Überraschenderweise können aus Polyolefinen mit den genannten Eigenschaften Haftklebemassen mit hoher Alterungsbeständigkeit, Klebkraft, Tack und Scherfestigkeit hergestellt werden, welche auf sehr vielen Untergründen eine hervorragende Haftung aufweisen, insbesondere auch auf niederenergetischen Oberflächen wie unpolaren Lacken oder Olefinpolymeren. Zudem weisen diese eine hervorragende Barrierewirkung gegen Wasser und Sauerstoff auf, insbesondere gegen Wasserdampf. Das Polyolefin weist vorzugsweise einen Schmelzindex von 0,5 bis 10 g/10 min., besonders bevorzugt 3 bis 8 g/10 min. auf. Der Biegemodul des Polyolefins beträgt vorzugsweise weniger als 50 MPa, besonders bevorzugt weniger als 26 MPa.

Das zur Verkapselung verwendete Polyolefin enthält vorzugsweise Ethylen, Propylen oder Buten-(1) als gewichtsmäßige Hauptkomponente und mindestens ein weiteres Comonomer ausgewählt aus den C2- bis C10-Olefinen, besonders bevorzugt aus den C2- bis C10-α-Olefinen und 4-Methyl-penten-(1). Besonders geeignet sind Copolymere aus Propylen und Ethylen, Ethylen und Octen, Buten-(1) und Propylen sowie Terpolymere aus Propylen, Buten-(1) und Ethylen und Propylen, Buten-(1) und 4-Methyl-penten-(1)

Das Polyolefin kann auf verschiedene Weise aufgebaut worden sein, zum Beispiel als Randomcopolymer, Blockcopolymer, als Pfropfpolymer oder als sogenannter Reaktorblend wie bei heterophasischen Polypropylenen (auch Impact Polypropylen oder nicht ganz richtig aber üblich Polypropylenblockcopolymer genannt).

Die Größe der Kristalle (deren mittlerer Durchmesser) des Polyolefins liegt vorzugsweise unter 100 nm, wodurch die Klebemasse eine hohe Transparenz aufweist. Ein solches Polyolefin kann mit einem Metallocenkatalysator z.B. auf Zirkonbasis hergestellt werden. Das Polyolefin weist vorzugsweise einen Haze-Wert von unter 8 auf (gemessen an 2 mm dicken Presslingen in Cyclohexanol).

Die Dichte des Polyolefin wird nach ISO 1183 ermittelt und in g/cm³ ausgedrückt. Der Schmelzindex wird nach ISO 1133 mit 2,16 kg geprüft und in g/10 min. ausgedrückt. Die in dieser Patentschrift genannten Werte werden, wie dem Fachmann geläufig ist, bei verschiedenen Temperaturen in Abhängigkeit von dem Hauptmonomer des Polymers bestimmt, sie liegt bei überwiegend Ethylen- oder 1-Buten-haltigen Polymeren bei 190°C und bei überwiegend Propylen-haltigen Polymeren bei 230°C. Der Biegemodul (flexural modulus) ist nach ASTM D 790 (2 % Secant) zu bestimmen. Der Kristallitschmelzpunkt (T_{cr}) und die Schmelzwärme werden mit DSC (Mettler DSC 822) bei einer Aufheizrate von 10 °C/min. nach ISO 3146 ermittelt, beim Auftreten mehrerer Schmelzpeaks wird der mit der höchsten Temperatur gewählt, da nur Schmelzpeaks oberhalb von 100°C in Haftklebstoffformulierungen erhalten bleiben und wirksam werden, wohingegen Schmelzpeaks erheblich unter 100°C im Wesentlichen nicht erhalten bleiben und keine Auswirkung auf die Produkteigenschaften haben. Die Schmelzwärme bestimmt einerseits Klebkraft und Tack der Formulierung und andererseits die Scherfestigkeit, insbesondere in der Wärme (also bei 70°C und darüber). Die Schmelzwärme des Polyolefins ist daher für den optimalen Kompromiss der klebtechnischen Eigenschaften von Bedeutung, sie liegt vorzugsweise zwischen 3 und 15 J/g, besonders bevorzugt zwischen 5 und 18 J/g. Die Schmelzwärme der Haftklebemasse selbst ist ebenfalls für einen optimalen Kompromiss der klebtechnischen Eigenschaften von Bedeutung, sie liegt vorzugsweise zwischen 1 und 6 J/g, besonders bevorzugt zwischen 2 und 5 J/g.

Der Gehalt an Polyolefin in der Klebemasse liegt vorzugsweise unter 60 Gewichts-%, besonders bevorzugt unter 40 Gewichts-% und insbesondere unter 30 Gewichts-%, wenn für die Haftklebemasse ein besonders guter Tack (Anfassvermögen, Klebrigkeit) erreicht werden soll.

Der Gehalt an Polyolefin in der Klebemasse liegt in einer anderen Ausführungsform vorzugsweise über 30 Gewichts-%, ganz bevorzugt über 50 Gew.-%, wenn eine besonders gute Permeationsbarriere gegen Wasserdampf erreicht werden soll. In diesem Fall kann es notwendig sein die Klebemasse unmittelbar vor der Applikation zu erwärmen um ausreichende Haftung zu erzielen. Nachteilig ist hier aber die aufgrund des verringerten Harzanteils die vergrößerte Sauerstoffpermeation.

Das Polyolefin kann mit den bei Kautschukmassen bekannten Elastomeren wie Naturkautschuk oder Synthesekautschuken kombiniert werden. Vorzugsweise werden ungesättigte Elastomere wie Naturkautschuk, SBR, NBR oder ungesättigte Styrolblockcopolymere nur in geringen Mengen oder besonders bevorzugt gar nicht verwendet. In der Hauptkette gesättigte Synthesekautschuke wie Polyisobutylen, Butylkautschuk, EPM, HNBR, EPDM oder hydrierte Styrolblockcopolymere werden für den Fall einer gewünschten Modifikation bevorzugt. Dies zeigen zudem eine Bessere Witterungsbeständigkeit, als ungesättigte Typen. Zur Erzielung guter Transparenz wird es vorzugsweise jedoch nicht mit einem Kautschuk kombiniert.

Es stellte sich überraschenderweise heraus dass Klebrigkeit (Tack) und Klebkraft der polyolefinbasierten Klebemasse im Gegensatz zu konventionellen Kautschukmassen von der Polydispersität des zugegebenen Harzes extrem abhängig sind. Die Polydispersität ist das Verhältnis von Gewichtsmittel zu Zahlenmittel der Molmassenverteilung und kann durch Gelpermeationschromatographie ermittelt werden. Als Klebharz werden daher solche mit einer Polydispersität von weniger als 2,1 vorzugsweise weniger als 1,8 besonders bevorzugt weniger als 1,6 eingesetzt. Der höchste Tack ist mit Harzen mit einer Polydispersität von 1,0 bis 1,4 zu erreichen.

Als Klebharz für die Haftklebemasse hat sich herausgestellt, dass Harze auf Basis von Kolophonium (zum Beispiel Balsamharz) oder Kolophoniumderivaten (zum Beispiel disproportioniertes, dimerisiertes oder verestertes Kolophonium), vorzugsweise partiell oder vollständig hydriert, gut geeignet sind. Sie verleihen der Haftklebemasse von allen Klebharzen den höchsten Tack (Klebrigkeit, Anfassvermögen), vermutlich liegt das an der geringen Polydispersität von 1,0 bis 1,2. Terpenphenolharze sind ebenfalls geeignet, führen aber nur zu mäßigem Tack, jedoch zu sehr guter Scherfestigkeit und Alterungsbeständigkeit. Polyterpenharze sind in der Regel aufgrund ihrer breiten Molmassenverteilung weniger geeignet.

Bevorzugt werden ebenfalls Kohlenwasserstoffharze da sie vermutlich aufgrund Ihrer Polarität gut verträglich sind. Dies sind zum Beispiel aromatische Harze wie Cumaron-Inden-Harze und/oder Harze auf Basis von Styrol oder α-Methylstyrol oder cycloaliphatische Kohlenwasserstoffharze aus der Polymerisation von C5-Monomeren wie Piperylen oder C5- , C8- oder C9-Fraktionen von Crackern. Bevorzugt werden diese Harze in teil- und und besonders bevorzugt in vollhydrierter Form. Besonders geeignet sind Kohlenwasserstoffharze gewonnen durch vollständige Hydrierung von aromatenhaltigen Kohlenwasserstoffharzen oder Cyclopentadien-Polymeren wie zum Beispiel Regalite 1125 oder Escorez 5320. Vorgenannte Klebharze können sowohl allein als auch im Gemisch eingesetzt werden. Dabei können sowohl bei Raumtemperatur feste als auch flüssige Harze zum Einsatz kommen.

Um eine hohe Alterungs- und UV-Stabilität zu gewährleisten sind hydrierte Harze mit einem Hydrierungsgrad von mindestens 90%, vorzugsweise von mindestens 95%, bevorzugt.

Die Menge an Klebharz beträgt vorzugsweise 130 bis 350 phr, besonders bevorzugt 200 bis 240 phr (phr bedeutet Gewichtsteile bezogen auf 100 Gewichtsteile Polymer, das heißt in unserem Fall Polyolefin).

Für eine Erhöhung der Barriereeigenschaften werden bevorzugt solche Klebharze eingesetzt, die unpolar sind und einem DACP-Wert (diacetone alcohol cloud point) oberhalb von 30°C und einem MMAP-Wert (mixed methylcylohexane aniline point) von größer 50°C, insbesondere einen DACP-Wert oberhalb von 37°C und einem MMAP-Wert größer 60°C, aufweisen. Der DACP-Wert und der MMAP-Wert geben jeweils die Löslichkeit in einem bestimmten Lösemittel an. Durch die Auswahl dieser Bereiche wird eine besonders hohe Permeationsbarriere, insbesondere gegen Wasserdampf, erreicht.

Die Haftklebemasse enthält vorzugsweise ein oder mehrere Additive besonders bevorzugt ausgewählt aus der Gruppe bestehend aus: Weichmacher, primären Antioxidanzien, sekundären Antioxidanzien, Prozessstabilisatoren, Lichtschutzmitteln, Verarbeitungshilfsmittel, UV-Blocker, Polymere.

Die Klebemasse enthält in einer bevorzugten Ausführung einen flüssigen Weichmacher wie beispielsweise aliphatische (paraffinische oder verzweigte), cycloaliphatische (naphthenische) und aromatische Mineralöle, Ester der Phthal-, Trimellit-, Zitronen- oder Adipinsäure, Wollwachs, flüssige Kautschuke (zum Beispiel niedermolekulare Nitril-, Butadien- oder Polyisoprenkautschuke), flüssige Polymerisate aus Isobuten und/oder Buten, Flüssig- und Weichharze mit einem Schmelzpunkt unter 40°C auf Basis der Rohstoffe von Klebharzen, insbesondere der oben aufgeführten Klassen an Klebharz. Besonders bevorzugt werden flüssige Isobutenpolymerisate wie Isobutenhomopolymer oder Isobuten-Buten-Copolymer und Ester der Phthal-, Trimellit-, Zitronen- oder Adipinsäure, insbesondere deren Ester von verzweigten Octanolen und Nonanolen.
Mineralöle eignen sich sehr gut, um das Polyolefin klebrig einzustellen, können aber in zu verklebende Untergründe einwandern. Die Klebemasse ist daher vorzugsweise im Wesentlichen frei von Mineralölen.

Anstelle eines flüssigen Weichmachers kann auch ein sehr weiches und kaum kristallines Olefinpolymer (Plastomer) zusätzlich zum Polyolefin verwendet werden. Dieses ist vorzugsweise ein Copolymer oder Terpolymer aus Ethylen oder Propylen kombiniert mit Ethylen, Propylen, Buten-(1), Hexen-(1), 4-Methylpenten (1) oder Octen-(1), welche zum Beispiel unter den Handelsnamen Exact™, Engage™ oder Tafmer™ bekannt sind, oder ein Terpolymer aus Ethylen, Propylen und Buten-(1), Hexen-(1), 4-Methylpenten (1) oder Octen-(1), wobei der Biegemodul vorzugsweise unter 20 MPa und/oder der Kristallitschmelzpunkt vorzugsweise unter 60°C und/oder die Dichte zwischen 0,86 und 0,87 g/cm³ liegt. Weitere bevorzugte Olefinpolymere sind EPDM, also Terpolymere aus Ethylen und Propylen und einem Dien wie Ethylidenenorbornen, vorzugsweise mit einem Ethylengehalt von 40 bis 70 Gewichts-%, einer Mooney-Viskosität (Bedingungen 1+4, 125°C) unter 50 und/oder einer Dichte unter 0,88, besonders bevorzugt unter 0,87 g/cm³. Da solche Olefinpolymere zwar sehr weich, verglichen mit einem flüssigen Weichmacher aber relativ hart sind, sollte die Menge im Verhältnis zum erfindungsgemäßen Polyolefin sehr hoch sein, also über 100 phr.

Dem Schmelzpunkt (Erweichungspunkt) des Klebharzes (Bestimmung nach DIN ISO 4625) kommt ebenfalls Bedeutung zu. Üblicherweise steigt die Klebkraft einer Kautschukhaftklebemasse (auf Basis Natur- oder Synthesekautschuk) mit dem Schmelzpunkt des Klebharzes an. Bei den beschriebenen Polyolefinen scheint sich das umgekehrt zu verhalten. Klebharze mit hohem Schmelzpunkt von 100°C bis 140°C sind diesbezüglich ungünstiger als solche mit einem Schmelzpunkt von unter 100°C. Wenn eine spezifische Anwendung einen hohen Tack und hohe Klebkraft erfordert, wird ein Klebharz mit niedrigerem Erweichungspunkt eingesetzt oder ein handelsübliches Produkt mit einem Weichmacher kombiniert, um faktisch den Schmelzpunkt des Harzes zu senken. Der Mischschmelzpunkt wird an einer homogenisierten Mischung aus Klebharz und Weichmacher ermittelt, wobei die beiden Komponenten im gleichen Verhältnis vorliegen wie in der entsprechenden Klebemasse. Der so eingestellte und ermittelte Schmelzpunkt liegt vorzugsweise im Bereich von 45°C bis 100°C.

Bei den meisten Anwendungen steht jedoch die Barrierewirkung der Masse im Vordergrund. Es wurde festgestellt, dass dafür nicht nur die Harzmenge von Bedeutung ist, sondern auch der Erweichungspunkt. Wenn also die Barrierewirkung gegen Sauerstoff besonders ausgeprägt sein soll und die Klebwirkung noch ausreicht, werden Harze mit einem Schmelzpunkt von mindestens 100°C bevorzugt oder die entsprechende Mischung aus einem Harz und einem Weichmacher.

Steht eine Verbesserung der Permeationsbarriere im Vordergrund werden bevorzugt Harze mit einer Erweichungstemperatur von mehr als 90 °C, insbesondere mehr als 100 °C für solche Ausführungsformen eingesetzt. Der eingestellt Harz/Weichmacher Schmelzpunkte liegt vorzugsweise bei mehr als 70°C, insbesondere bei mehr als 80°C. Durch diese Auswahl wird eine hohe Permeationsbarriere, insbesondere gegen Sauerstoff, erreicht.

Die Einstellung der Erweichungstemperatur erfolgt in Abhängigkeit von den Anforderungen des (opto-) elektronischen Aufbaus, um eine optimale Balance zwischen Klebkraft, Tack, Kohäsion und Barrierewirkung der Haftklebemasse zu erzielen.

Konventionelle Klebmassen auf Basis von Naturkautschuk oder ungesättigten Styrolblockcopolymeren als Elastomerkomponente enthalten üblicherweise ein phenolisches Antioxidans zur Vermeidung des oxidativen Abbaus dieser Elastomerkomponente mit Doppelbindungen in der Polymerkette. Die vorliegend verwendete Klebemasse enthält jedoch ein Polyolefin ohne oxidationsempfindliche Doppelbindungen und kann daher auch ohne Antioxidans auskommen. Zur Optimierung der Eigenschaften kann die zum Einsatz kommende Selbstklebemasse beziehungsweise der Haftkleber aber auch mit weiteren Additiven wie primäre und sekundäre Antioxidantien, Flammschutzmitteln, Pigmenten, UV-Absorbern, Antiozonantien, Metalldesaktivatoren, Lichtschutz- und/oder Flammschutzmitteln abgemischt sein.

Vorzugsweise werden ein primäres Antioxidans und besonders bevorzugt auch ein sekundäres Antioxidans verwendet. Die erfindungsgemäßen Klebemassen enthalten in den bevorzugten Ausführungsformen mindestens 2 phr, besonders bevorzugt 6 phr primäres Antioxidans oder, vorzugsweise, mindestens 2 phr, insbesondere mindestens 6 phr einer Kombination aus primären und sekundären Antioxidans, wobei die primäre und sekundäre Antioxidansfunktion nicht in verschiedenen Molekülen vorliegen muss, sondern auch in einem Molekül vereinigt sein kann. Die Menge an sekundärem Antioxidans beträgt bevorzugt bis 5 phr, besonders bevorzugt 0,5 bis 1 phr. Überraschend wurde gefunden, dass eine Kombination von primären Antioxidantien (zum Beispiel sterisch gehinderten Phenolen oder C-Radikalfängern wie CAS 181314-48-7) und sekundären Antioxidantien (zum Beispiel Schwefelverbindungen, Phosphiten oder sterisch gehinderten Aminen) eine verbesserte Verträglichkeit ergibt. Vor allem wird die Kombination von einem primären Antioxidans, vorzugsweise sterisch gehinderten Phenolen mit einer relativen Molmasse von mehr als 500 Dalton, mit einem sekundären Antioxidans aus der Klasse der Schwefelverbindungen oder aus der Klasse der Phosphite, bevorzugt mit einer relativen Molmasse von mehr als 500 Dalton, bevorzugt, wobei die phenolische, die schwefelhaltigen und die phosphitische Funktionen nicht in drei verschiedenen Molekülen vorliegen müssen, sondern auch mehr als eine Funktion in einem Molekül vereinigt sein können.

In einer weiteren Ausführung werden die erfindungsgemäß eingesetzten Haftklebemassen bevorzugt vor oder ggf. auch nach dem Auffließen auf die Oberfläche vernetzt, wobei solche Vernetzungsgrade angestrebt werden, die weiterhin eine hohe Flexibilität und gute Haftung des Materials ermöglichen. Nach der Vernetzung weist die Haftklebemasse bevorzugt eine Reißdehnung von mindestens 20% auf. Eine derartige Reißdehnung ist besonders bevorzugt im Hinblick auf eine möglichst flexible Ausgestaltung der Haftklebemasse. Die Reißdehnung wird bestimmt bei einer Dehngeschwindigkeit von 300 mm/min und einer Temperatur von 23°C.

In einer bevorzugten Vorgehensweise wird die Haftklebemasse mit UV-Strahlung oder Elektronenstrahlen vernetzt. Eine ausführliche Beschreibung des Standes der Technik und die wichtigsten Verfahrensparameter bezüglich der Vernetzung sind dem Fachmann beispielsweise aus "Chemistry and Technology of UV and EB formulation for Coatings, Inks and Paints" (Vol. 1, 1991, SITA, London) bekannt. Zudem können auch andere Verfahren eingesetzt werden, die hochenergetische Bestrahlung ermöglichen.

Zur Verringerung der erforderlichen Strahlendosis können dem viskoelastischen Material Vernetzer und/oder Promotoren zur Vernetzung beigemischt werden, insbesondere durch UV-, Elektronenstrahlen- und/oder thermisch anregbare Vernetzer und/oder Promotoren. Geeignete Vernetzer für die Strahlenvernetzung sind Monomere oder Polymere die beispielsweise folgende funktionelle Gruppen beinhalten: Acrylat oder Methacrylat, Epoxid, Hydroxy, Carboxy, Vinyl, Vinylether, Oxetan, Thiol, Acetoacetat, Isocyanate, Allyl oder allgemein ungesättigte Verbindungen. Die eingesetzten Monomere oder Polymere können, je nach den Anforderungen an den Vernetzungsgrad di- oder multifunktionell sein.

In einer weiteren bevorzugten Auslegung werden die Haftklebemassen mit thermisch aktivierbaren Vernetzern vernetzt. Hierzu werden bevorzugt Peroxide, Säure- oder Säureanhydride, Metallchelate, bi- oder multifunktionelle Epoxide, bi- oder multifunktionelle Hydroxide sowie bi- oder multifunktionelle Isocyanate beigemischt, wie sie etwa für Säureanhydride in EP 1311559 B1 beschrieben werden.

Neben den monomeren Vernetzern mit den beschriebenen funktionellen Gruppen werden bevorzugt Polymere eingesetzt, die mit diesen vernetzenden Gruppen funktionalisiert sind. Es können vorteilhaft funktionalisierte Blockcopolymere wie die Kraton FG-Serie (etwa Kraton FG 1901 oder Kraton FG 1924), Asahi Tuftec M 1913 bzw. Tuftec M 1943 oder Septon HG252 (SEEPS-OH) eingesetzt werden. Weitere bevorzugte Blockcopolymere sind zum Beispiel unter dem Namen Epofriend A 1005, A 1010 oder A 1020 der Firma Daicel erhältlich. Durch Zugabe geeigneter Vernetzungsagentien (zum Beispiel mehrwertige Isocyanate, Amine, Epoxide, Alkohole, Thiole, Phenole, Guanidine, Mercaptane Carbonsäuren bzw. Säureanhydride) können diese Blockcopolymere thermisch oder durch Strahlung vernetzt werden. Auch eine Kombination von säure- oder säureanhydridmodifizierten Blockcopolymer (zum Beispiel Kraton FG-Serie) und einem epoxidierten Blockcopolymer (zum Beispiel Daicel Epofriend-Serie) ist vorteilhaft nutzbar. Dadurch kann man eine Vernetzung ohne monomeren Vernetzer bewerkstelligen, wodurch auch bei unvollständiger Vernetzung keine monomeren Bestandteile übrig bleiben. Eine weitere Möglichkeit ist der Einsatz von funktionalisiertem Polyisobutylen, wie es unter dem Namen Epion von der Firma Kaneka erhältlich ist. Dieses kann über Kondensationsreaktionen, Hydrosilane oder verschiedene oben genannte Techniken, wie Elektronenstrahlen, weitere Vernetzer oder Radikalstarter verknüpft werden. Eine Mischung von funktionalisierten Monomere oder Polymere ist ebenfalls einsetzbar.

In einer weiteren Ausführungsform enthält die Haftklebemasse auch Füllstoffe, beispielhaft, aber nicht einschränkend erwähnt seien Oxide, Hydroxide, Carbonate, Nitride, Halogenide, Carbide oder gemischte Oxid-/ Hydroxid-/ Halogenid-verbindungen des Aluminiums, Siliciums, Zirkoniums, Titans, Zinns, Zinks, Eisens oder der (Erd)alkalimetalle. Hierbei handelt es sich im Wesentlichen um Tonerden z.B. Aluminiumoxide, Boehmit, Bayerit, Gibbsit, Diaspor und ähnliche. Ganz besonders geeignet sind Schichtsilicate wie beispielsweise Bentonit, Montmorillonit, Hydrotalcit, Hectorit, Kaolinit, Boehmit, Glimmer, Vermiculit oder deren Mischungen. Aber auch Ruße oder weitere Modifikationen des Kohlenstoffs, etwa Kohlenstoffnanoröhrchen, hohle Körper aus Glas oder Vollglaskörper oder Polymeren insbesondere Hohlkugeln oder Glas- oder Polymerfasern können verwendet werden.

Bevorzugt werden als Füllstoffe der Haftklebmasse nanoskalige und/oder transparente Füllstoffe verwendet. Als nanoskalig wird ein Füllstoff vorliegend bezeichnet, wenn er in mindestens einer Dimension eine maximale Ausdehnung von etwa 100 nm, bevorzugt von etwa 10 nm, aufweist. Besonders bevorzugt werden solche in der Masse transparente Füllstoffe mit plättchenförmiger Kristallitstruktur und einem hohen Aspektverhältnis bei homogener Verteilung verwendet. Die Füllstoffe mit plättchenartiger Kristallitstruktur und Aspektverhältnissen weit über 100 haben in der Regel nur eine Dicke von einigen nm, die Länge bzw. die Breite der Kristallite kann aber bis zu einigen µm betragen. Derartige Füllstoffe werden ebenfalls als Nanopartikel bezeichnet. Die partikuläre Ausgestaltung der Füllstoffe mit kleinen Abmessungen ist zudem besonders vorteilhaft für eine transparente Auslegung der Haftklebemasse.

Durch den Aufbau labyrinthartiger Strukturen mithilfe der zuvor beschriebenen Füllstoffe in der Haftklebstoffmatrix wird der Diffusionsweg von zum Beispiel Sauerstoff und Wasserdampf derartig verlängert, dass ihre Permeation durch die Haftklebstoffschicht hindurch vermindert wird. Zur besseren Dispergierbarkeit dieser Füllstoffe in der Bindemittelmatrix können diese Füllstoffe mit organischen Verbindungen oberflächlich modifiziert: werden. Der Einsatz derartiger Füllstoffe an sich ist beispielsweise aus der US 2007/0135552 A1 sowie der WO 02/026908 A1 bekannt.

In einer weiteren vorteilhaften Ausführung der vorliegenden Erfindung werden auch Füllstoffe, die mit Sauerstoff und/oder Wasserdampf in besonderer Weise wechselwirken können, eingesetzt. In die (opto-) elektronische Anordnung eindringender Sauerstoff oder Wasserdampf wird dann an diesen Füllstoffen chemisch oder physikalisch gebunden. Diese Füllstoffe werden auch als "getter", "scavenger", "desiccants" oder "absorber" bezeichnet. Solche Füllstoffe umfassen beispielhaft, aber nicht einschränkend: oxidierbare Metalle, Halide, Salze, Silicate, Oxide, Hydroxide, Sulfate, Sulfite, Carbonate von Metallen und Übergangsmetallen, Perchlorate und aktivierten Kohlenstoff, einschließlich seiner Modifikationen. Beispiele sind Cobaltchlorid, Calciumchlorid, Calciumbromid, Lithiumchlorid, Zinkchlorid, Zinkbromid, Siliciumdioxid (Silica Gel), Aluminiumoxid (aktiviertes Aluminium), Calciumsulfat, Kupfersulfat, Natriumdithionit, Natriumcarbonat, Magnesiumcarbonat, Titandioxid, Bentonit, Montmorillonit, Diatomenerde, Zeolithe und Oxide von (Erd)Alkalimetallen, wie Bariumoxid, Calciumoxid, Eisenoxid und Magesiumoxid oder auch Kohlenstoffnanoröhrchen. Desweiteren können auch organische Absorber, wie beispielsweise, Polyolefin-Copolymere, Polyamid-Copolymere, PET-Copolyester oder weitere auf Hybridpolymeren basierte Absorber, die meist in Kombination mit Katalysatoren wie beispielsweise Cobalt verwendet werden. Weitere organische Absorber sind etwa schwach vernetzte Polyacrylsäure, Ascorbate, Glucose, Gallussäure oder ungesättigte Fette und Öle.

Um eine möglichst gute Wirksamkeit der Füllstoffe hinsichtlich der Barrierewirkung zu erzielen sollte ihr Anteil nicht zu gering sein. Der Anteil beträgt vorzugsweise mindestens 5 Gew.-%, weiter bevorzugt mindestens 10 Gew.-% und ganz bevorzugt mindestens 15 Gew.-%. Typischerweise wird ein möglichst hoher Anteil von Füllstoffen eingesetzt, ohne dabei die Klebkräfte der Haftklebemasse zu stark herabzusetzen oder weitere Eigenschaften zu beeinträchtigen. Der Anteil beträgt daher in einer Auslegung maximal 95 Gew.-%, bevorzugt maximal 70 Gew.-%, weiter bevorzugt maximal 50 Gew.-%.

Des Weiteren ist eine möglichst feine Verteilung und möglichst hohe Oberfläche der Füllstoffe vorteilhaft. Dies ermöglicht einen höheren Wirkungsgrad und eine höhere Beladungskapazität und wird insbesondere mit nanoskaligen Füllstoffen erreicht.

Die Herstellung und Verarbeitung der Haftklebemasse kann aus Lösung, Dispersion sowie aus der Schmelze erfolgen. Bevorzugt erfolgt die Herstellung und Verarbeitung aus Lösung oder aus der Schmelze. Eine bevorzugte Variante ist die Fertigung der Klebmasse aus Lösung. Dabei werden die Bestandteile der Haftklebemasse in einem geeigneten Lösungsmittel, zum Beispiel Toluol oder Mischungen aus Benzin, Toluol und Aceton, gelöst und mit allgemein bekannten Verfahren auf den Träger aufgebracht. Bei Verfahren aus der Lösung sind Beschichtungen mit Rakeln, Messern, Walzen oder Düsen bekannt, um nur einige zu nennen.

Eine Alternative ist die Herstellung und Verarbeitung aus der Schmelze. In diesem Fall umfassen geeignete Herstellprozesse sowohl Batchverfahren als auch kontinuierliche Verfahren. Besonders bevorzugt ist die kontinuierliche Fertigung der Haftklebemasse mit Hilfe eines Extruders und anschließender Beschichtung direkt auf das zu beschichtende Substrat bei entsprechend hoher Temperatur der Klebmasse. Als Beschichtungsverfahren für Haftklebemassen werden Extrusionsbeschichtung mit Breitschlitzdüsen und Kalanderbeschichtung und bei nichthaftklebrigen Schmelzklebern Breitschlitzdüsen, Schmelzklebepistolen und Düsen zum Spinnen von Klebstofffäden bevorzugt. Weitere Ausführungsformen sind Kaschierung und Coextrusion mit einem Träger (zum Beispiel einer Folie).

Die Haftklebemasse kann entweder zur vollflächigen Verklebung von (opto-) elektronischen Anordnungen verwendet werden oder nach entsprechender Konfektionierung können Stanzlinge, Rollen oder sonstige Formkörper aus der Haftklebemasse oder dem Haftklebeband hergestellt werden. Entsprechende Stanzlinge und Formkörper der Haftklebemasse / des Haftklebebandes werden dann vorzugsweise auf das zu verklebende Substrat aufgeklebt, etwa als Umrandungen oder Begrenzung einer (opto-)elektronischen Anordnung. Die Wahl der Form des Stanzlings oder des Formkörpers ist nicht eingeschränkt und wird abhängig von der Art der (opto-) elektronischen Anordnung gewählt. Die Möglichkeit der flächigen Laminierung ist, im Vergleich zu Flüssigklebstoffen durch die Erhöhung der Permeationsweglänge durch seitliches Eindringen der Permeanten von Vorteil für die Barriereeigenschaften der Masse, da die Permeationsweglänge sich umgekehrt proportional auf die Permeation auswirkt.

Sofern die Haftklebemasse in Form eines flächigen Gebildes mit einem Träger bereitgestellt wird, ist bevorzugt, dass die Dicke des Trägers bevorzugt im Bereich von etwa µm 1 bis etwa 350 µm liegt, weiter bevorzugt zwischen etwa 2 µm und etwa 250 µm und besonders bevorzugt zwischen etwa 12 µm und etwa 150 µm. Die optimale Dicke hängt von der (opto-) elektronischen Anordnung, der Endanwendung und der Art der Ausführung der Haftklebemasse ab. Sehr dünne Träger im Bereich von 1 bis 12 µm werden eingesetzt bei (opto-) elektronische Aufbauten, die eine geringe Gesamtdicke erreichen sollen, es wird jedoch der Aufwand für die Integration in den Aufbau erhöht. Sehr dicke Träger zwischen 150 und 350 µm werden eingesetzt wenn eine erhöhte Permeationsbarriere durch den Trägers und die Steifigkeit des Aufbaus im Vordergrund stehen; die Schutzwirkung wird durch den Träger erhöht, während die Flexibilität des Aufbaus verringert wird. Der bevorzugte Bereich zwischen 12 und 150 µm stellt für die meisten (opto-) elektronischen Aufbauten einen optimalen Kompromiss als Verkapselungslösung dar.

Weitere Einzelheiten, Ziele, Merkmale und Vorteile der vorliegenden Erfindung werden nachfolgend anhand bevorzugter Ausführungsbeispiele näher erläutert. In der Zeichnung zeigt
- Fig. 1: eine erste (opto-) elektronische Anordnung in schematischer Darstellung,
- Fig. 2: eine zweite (opto-) elektronische Anordnung in schematischer Darstellung,
- Fig. 3: eine dritte (opto-) elektronische Anordnung in schematischer Darstellung.

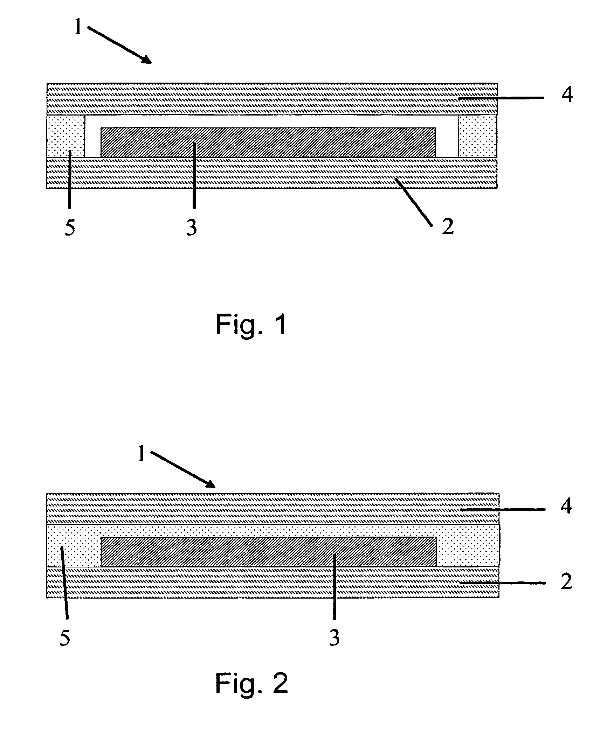

Fig. 1 zeigt eine erste Ausgestaltung einer (opto-) elektronischen Anordnung 1. Diese Anordnung 1 weist ein Substrat 2 auf, auf dem eine elektronische Struktur 3 angeordnet ist. Das Substrat 2 selbst ist als Barriere für Permeanten ausgebildet und bildet damit einen Teil der Kapselung der elektronischen Struktur 3. Oberhalb der elektronischen Struktur 3, vorliegend auch räumlich von dieser beabstandet, ist eine weitere als Barriere ausgebildete Abdeckung 4 angeordnet.

Um die elektronische Struktur 3 auch zur Seite hin zu kapseln und gleichzeitig die Abdeckung 4 mit der elektronischen Anordnung 1 im Übrigen zu verbinden, ist eine Haftklebemasse 5 umlaufend neben der elektronischen Struktur 3 auf dem Substrat 2 vorgesehen. Die Haftklebemasse 5 verbindet die Abdeckung 4 mit dem Substrat 2. Durch eine entsprechend dicke Ausgestaltung ermöglicht die Haftklebemasse 5 zudem die Beabstandung der Abdeckung 4 von der elektronischen Struktur 3.

Bei der Haftklebemasse 5 handelt es sich um eine solche auf Basis der erfindungsgemäßen Haftklebemasse wie sie vorstehend in allgemeiner Form beschrieben wurde und nachfolgend in Ausführungsbeispielen näher dargelegt ist. Die Haftklebemasse 5 übernimmt vorliegend nicht nur die Funktion des Verbindens des Substrats 2 mit der Abdeckung 4 sondern bildet zudem auch eine Barriereschicht für Permeanten bereit, um so die elektronische Struktur 2 auch von der Seite gegen Permeanten wie Wasserdampf und Sauerstoff zu kapseln.

Die Haftklebemasse 5 wird vorliegend zudem in Form eines Stanzlings aus einem doppelseitigen Klebebandes bereitgestellt. Ein derartiger Stanzling ermöglicht eine besonders einfache Applikation.

Fig. 2 zeigt eine alternative Ausgestaltung einer (opto-) elektronischen Anordnung 1. Gezeigt ist wiederum eine elektronische Struktur 3, die auf einem Substrat 2 angeordnet und durch das Substrat 2 von unten gekapselt ist. Oberhalb und seitlich von der elektronischen Struktur ist nun die Haftklebemasse 5 vollflächig angeordnet. Die elektronische Struktur 3 wird somit von oben vollständig durch die Haftklebemasse 5 gekapselt. Auf die Haftklebemasse 5 ist sodann eine Abdeckung 4 aufgebracht. Diese Abdeckung 4 muss im Gegensatz zu der vorherigen Ausgestaltung nicht zwingend die hohen Barriereanforderungen erfüllen, da die Barriere bereits durch die Haftklebemasse bereitgestellt wird. Die Abdeckung 4 kann beispielsweise lediglich eine mechanische Schutzfunktion wahrnehmen, sie kann aber auch zusätzlich als Permeationsbarriere vorgesehen sein.

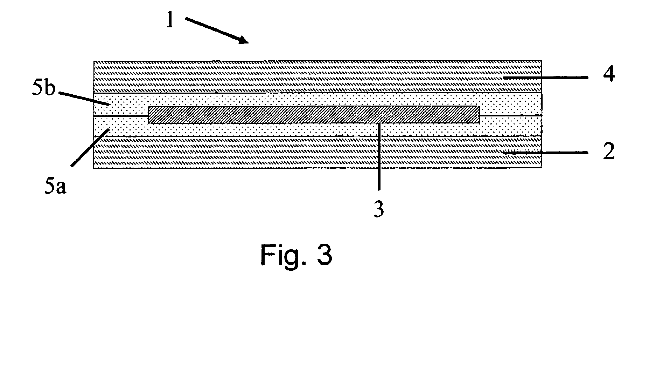

Fig. 3 zeigt eine weitere alternative Ausgestaltung einer (opto-) elektronischen Anordnung 1. Im Gegensatz zu den vorherigen Ausgestaltungen sind nun zwei Haftklebemassen 5a, b vorgesehen, die vorliegend identisch ausgebildet sind. Die erste Haftklebemasse 5a ist vollflächig auf dem Substrat 2 angeordnet. Auf der Haftklebemasse 5a ist die elektronische Struktur 3 vorgesehen, die durch die Haftklebemasse 5a fixiert wird. Der Verbund aus Haftklebemasse 5a und elektronischer Struktur 3 wird dann mit der weiteren Haftklebemasse 5b vollflächig überdeckt, so dass die elektronische Struktur 3 von allen Seiten durch die Haftklebemassen 5a, b gekapselt ist. Oberhalb der Haftklebemasse 5b ist wiederum die Abdeckung 4 vorgesehen.

In dieser Ausgestaltung müssen somit weder das Substrat 2 noch die Abdeckung 4 zwingend Barriereeigenschaften aufweisen. Sie können aber dennoch vorgesehen sein, um die Permeation von Permeanten zur elektronischen Struktur 3 weiter einzuschränken.

Insbesondere im Hinblick auf die Fig. 2,3 wird darauf hingewiesen, dass es sich vorliegend um schematische Darstellungen handelt. Aus den Darstellungen ist insbesondere nicht ersichtlich, dass die Haftklebemasse 5 hier und vorzugsweise jeweils mit einer homogenen Schichtdicke aufgetragen wird. Am Übergang zur elektronischen Struktur bildet sich daher keine scharfe Kante, wie es in der Darstellung scheint, sondern der Übergang ist fließend und es können vielmehr kleine un- oder gasgefüllte Bereiche verbleiben. Ggf. kann jedoch auch eine Anpassung an den Untergrund erfolgen, insbesondere dann, wenn die Applikation unter Vakuum durchgeführt wird. Zudem wird die Haftklebemasse lokal unterschiedlich stark komprimiert, so dass durch Fließprozesse ein gewisser Ausgleich der Höhendifferenz an den Kantenstrukturen erfolgen kann. Auch die gezeigten Dimensionen sind nicht maßstäblich, sondern dienen vielmehr nur einer besseren Darstellung. Insbesondere die elektronische Struktur selbst ist in der Regel relativ flach ausgebildet (oft weniger als 1 µm dick).

Die Applikation der Haftklebemasse 5 erfolgt in allen gezeigten Ausführungsbeispielen in Form eines Haftklebebandes. Dabei kann es sich grundsätzlich um ein doppelseitiges Haftklebeband mit einem Träger oder um ein Transferklebeband handeln. Vorliegend ist eine Ausgestaltung als Transferklebeband gewählt.

Die Dicke der Haftklebemasse beträgt bevorzugt zwischen etwa 1 µm und etwa 150 µm, bevorzugt zwischen etwa 5 µm und etwa 75 µm und besonders bevorzugt zwischen etwa 12 µm und 50 µm. Hohe Schichtdicken zwischen 50 µm und 150 µm werden dann eingesetzt wenn eine verbesserte Haftung auf dem Substrat und/oder eine dämpfende Wirkung innerhalb des (opto-) elektronischen Aufbaus erreicht werden soll. Nachteilig ist hier jedoch der erhöhte Permeationsquerschnitt.

Wenn die Permeation im Vordergrund steht werden geringe Schichtdicken zwischen 1 µm und 12 µm eingesetzt, sie reduzieren den Permeationsquerschnitt und damit die laterale Permeation und die Gesamtdicke des (opto-) elektronischen Aufbaus. Jedoch kann es zu einer Verringerung der Haftung aus dem Substrat kommen.

In den besonders bevorzugten Dickenbereichen liegt ein guter Kompromiss zwischen einer geringen Massendicke und dem daraus folgenden niedrigen Permeationsquerschnitt, der die laterale Permeation verringert, und einem genügend dicken Massefilm zur Herstellung einer ausreichend haftenden Verbindung vor. Die optimale Dicke hängt vom (opto-) elektronischen Aufbau, der Endanwendung, der Art der Ausführung der Haftklebemasse und gegebenenfalls dem flächigen Substrat ab.

### Beispiele

Sofern nicht anders angegeben, sind alle Mengenangaben in den nachfolgenden Beispielen Gewichtsprozente bzw. Gewichtsteile bezogen auf die Gesamtzusammensetzung. Sofern keine abweichenden Bedingungen angegeben sind, wurden die Messungen bei 23°C (Raumtemperatur - RT) und einer relativen Luftfeuchte von 50% durchgeführt

### Klebkraft

Die Bestimmung der Klebkraft wurde wie folgt durchgeführt: Als definierter Haftgrund wurde eine Stahlfläche und eine Polyethylen-Platte (PE) eingesetzt. Das zu untersuchende verklebbare Flächenelement wurde auf eine Breite von 20 mm und eine Länge von etwa 25 cm zugeschnitten, mit einem Handhabungsabschnitt versehen und unmittelbar danach fünfmal mit einer Stahlrolle von 4 kg bei einem Vorschub von 10 m/min auf den jeweils gewählten Haftgrund aufgedrückt. Die Dicke der Haftklebeschicht beträgt 30 µm. Unmittelbar im Anschluss daran wurde das zuvor verklebte Flächenelement in einem Winkel von 180° bei Raumtemperatur und mit 300 mm/min vom Haftgrund mit einem Zugprüfungsgerät (Firma Zwick) abgezogen und die hierfür benötigte Kraft gemessen. Der Messwert (in N/cm) ergab sich als Mittelwert aus drei Einzelmessungen.

### Permeation

Die Bestimmung der Permeabilität für Sauerstoff (OTR) und Wasserdampf (WVTR) erfolgte nach DIN 53380 Teil 3 bzw. ASTM F-1249. Die Haftklebemasse wurde dazu mit einer Schichtdicke von 50 µm auf eine permeable Membran aufgebracht. Für die Sauerstoffdurchlässigkeit wurde bei 23°C und einer relativen Feuchte von 50 % gemessen mit einem Messgerät Mocon OX-Tran 2/21. Die Wasserdampfdurchlässigkeit wurde bei 37,5°C und einer relativen Feuchte von 90 % mit einem Messgerät Mocon Permatran W 3/33 bestimmt.

### Lebensdauertest

Als ein Maß für die Bestimmung der Lebensdauer eines (opto-) elektronischen Aufbaus wurde ein Calciumtest herangezogen. Dazu wird unter Stickstoffatmosphäre eine 20 x 20 mm² große, dünne Calciumschicht auf eine Glasplatte abgeschieden. Die Dicke der Calciumschicht liegt bei etwa 100 nm. Für die Verkapselung der Calciumschicht wird ein Klebeband mit einer PET/CPP-Barrierefolie als Trägermaterial verwendet (WVTR = 8 x 10⁻² g/m²*d und OTR = 6 x 10⁻² cm3/m²*d*bar, entsprechend nach ASTM F-1249 und DIN 53380 Teil 3 und oben genannten Bedingungen). Die Klebemasse ist auf der CPP-Seite der Barrierefolie aufgebracht. Das so erhaltene Klebeband wird mit einem allseitigen Rand von 5 mm über dem Calciumspiegel appliziert, in dem es direkt auf der Glasplatte haftet.

Der Test basiert auf der Reaktion von Calcium mit Wasserdampf und Sauerstoff, wie sie beispielsweise von A.G. Erlat et. al. in "47th Annual Technical Conference Proceedings - Society of Vacuum Coaters", 2004, Seiten 654-659, und von M. E. Gross et al. in "46th Annual Technical Conference Proceedings — Society of Vacuum Coaters", 2003, Seiten 89-92, beschrieben sind. Dabei wird die Lichttransmission der Calciumschicht überwacht, welche durch die Umwandlung in Calciumhydroxid und Calciumoxid zunimmt. Das Erreichen von 90 % der Transmission des Aufbaus ohne Calciumschicht wird als Ende der Lebensdauer bezeichnet. Als Messbedingungen werden 23°C und 50 % relative Luftfeuchte gewählt. Die Muster wurden mit einer Schichtdicke der Haftklebemasse von 25 µm vollflächig und blasenfrei verklebt.

### Herstellung der Muster

Die Haftklebemassen in Beispiel 1 bis 8 sowie Vergleichsbeispiel V5 wurden aus der Schmelze in einem Batchprozess mittels Laborkneters bei 120 - 190 °C hergestellt, je nach Kristallitschmelzpunkt des Polymers. Es erfolgt eine Beschichtung direkt auf das zu beschichtende Substrat (silikonisiertes Trennpapier) bei einer Temperatur der Klebmasse zwischen 120 °C und 160 °C und einer Schichtdicke von 30 bzw. 50 µm. Als Beschichtungsverfahren wird eine Kalanderbeschichtung verwendet. Für die Klebkraftmessungen wird die Haftklebemasse auf eine 23µm PET Folie kaschiert. Für den Permeationstest wurden Muster in gleicher Weise erstellt, jedoch erfolgte die Kaschierung der Haftklebemasse nicht auf eine PET-Folie auf eine permeable Membran, so dass eine Messung an der Haftklebemasse vorgenommen werden konnte.

### Rezepturen

| Beispiel 1 | | |
|---|---|---|
| Koattro KT AR85 | 24 | Copolymer aus Ethylen mit Buten-(1), Schmelzindex 0,8 g/10min, Dichte 0,890 g/cm³, Biegemodul 20 MPa, Kristallitschmelzpunkt 112°C |
| Ondina 933 | 20 | Weißöl (paraffinisch-naphthenisches Mineralöl) |
| Foral 85 | 54 | vollhydriertes Glycerinester des Kolophoniums mit einem Schmelzpunkt von 85°C und einer Polydispersität von 1,2 |
| Irganox 1076 | 2 | Phenolisches Antioxidans |

| Beispiel 2 | | |
|---|---|---|
| Versify DE 2400 | 24 | Copolymer aus Ethylen und Propylen, Schmelzindex 2 g/10min, Dichte 0,866 g/cm³, Biegemodul 2 MPa, Kristallitschmelzpunkt 130°C |
| Ondina 933 | 20 | Weißöl (paraffinisch-naphthenisches Mineralöl) |
| Regalite 1100 | 54 | C5-Kohlenwasserstoffharz, aromatisch, voll hydriert, Aromatengehalt nach Hydrierung = 0, Schmelzpunkt 100°C, Polydispersität 1,4 |
| Irganox 1076 | 2 | Phenolisches Antioxidans |

| Beispiel 3 | | |
|---|---|---|
| PB 8640M | 24 | Copolymer aus 1-Buten mit Ethylen, Schmelzindex 1 g/10min Dichte 0,906 g/cm³, Biegemodul 300 MPa, Kristallitschmelzpunkt 113 °C |
| Ondina 933 | 20 | Weißöl (paraffinisch-naphthenisches Mineralöl) |
| Wingtack Extra | 54 | aromatisch modifiziertes C5-Kohlenwasserstoffharz, Schmelzpunkt 95°C; Polydispersität 1,4 |
| Irganox 1076 | 2 | Phenolisches Antioxidans |

| Beispiel 4 | | |
|---|---|---|
| Softcell CA02A | 24 | Copolymer aus Propylen und Ethylen, Schmelzindex 0,6 g/10min, Dichte 0,870 g/cm³, Biegemodul 20 MPa, Kristallitschmelzpunkt 142°C, Schmelzwärme 9,9 J/g |
| Ondina 933 | 20 | Weißöl (paraffinisch-naphthenisches Mineralöl) |
| Foral 85 | 54 | vollhydriertes Glycerinester des Kolophoniums mit einem Schmelzpunkt von 85°C und einer Polydispersität von 1,2 |
| Irganox 1076 | 2 | Phenolisches Antioxidans |

| Beispiel 5 | | |
|---|---|---|
| Vistamaxx VM1100 | 12 | Copolymer aus Propylen und Ethylen; MFR = 4 g/10min; MFI= 2, Dichte= 0,862 g/cm³; Kristallitschmelzpunkt von 148 °C |
| Vistamaxx VM3000 | 12 | Copolymer aus Propylen und Ethylen; MFR = 7 g/10min; MFI= 3, Dichte= 0,871 g/cm³, Kristallitschmelzpunkt von 34 °C |
| Ondina 933 | 20 | Weißöl (paraffinisch-naphthenisches Mineralöl) |
| Foral 85 | 54 | vollhydriertes Glycerinester des Kolophoniums mit einem Schmelzpunkt von 85°C und einer Polydispersität von 1,2 |
| Irganox 1076 | 2 | Phenolisches Antioxidans |

| Beispiel 6 | | |
|---|---|---|
| Notio PN 0040 | 24 | Terpolymer aus Propylen mit den Comonomeren Buten-(1) und 4-Methylpenten-(1), Schmelzindex 4g/10min, Dichte 0,868 g/cm³, Biegemodul 42 MPa, Kristallitschmelzpunkt 159°C, Schmelzwärme 5,2 J/g, Elastizitätsmodul G' (23°C) 0,6 MPa, Verlustfaktor tan δ (23 °C) 0,14 |
| Oppanol B10 | 20 | Polyisobuten; flüssig; Dichte = 0,93 g/cm³; Mₙ = 40000 g/mol |
| Foral 85 | 54 | vollhydriertes Glycerinester des Kolophoniums mit einem Schmelzpunkt von 85°C und einer Polydispersität von 1,2 |
| Irganox 1076 | 2 | Phenolisches Antioxidans |

| Beispiel 7 | | |
|---|---|---|
| Tafcelen T3714 | 24 | Terpolymer aus 1-Buten, Propylen und Ethylen, Schmelzindex 3 g/10min, Dichte 0,860 g/cm³, Biegemodul 1 MPa, kein Kristallitschmelzpunkt erkennbar |
| Oppanol B10 | 20 | Polyisobuten; flüssig; Dichte = 0,93 g/cm³; Mₙ = 40000 g/mol |
| Foral 85 | 54 | vollhydriertes Glycerinester des Kolophoniums mit einem Schmelzpunkt von 85°C und einer Polydispersität von 1,2 |
| Irganox 1076 | 2 | Phenolisches Antioxidans |

| Beispiel 8 | | |
|---|---|---|
| Notio PN 0040 | 24 | Terpolymer aus Propylen mit den Comonomeren Buten-(1) und 4-Methylpenten-(1), Schmelzindex 4g/10min, Dichte 0,868 g/cm³, Biegemodul 42 MPa, Kristallitschmelzpunkt 159°C, Schmelzwärme 5,2 J/g, Elastizitätsmodul G' (23°C) 0,6 MPa, Verlustfaktor tan δ (23 °C) 0,14 |
| Ondina 933 | 20 | Weißöl (paraffinisch-naphthenisches Mineralöl) |
| Foral 85 | 54 | vollhydriertes Glycerinester des Kolophoniums mit einem Schmelzpunkt von 85°C und einer Polydispersität von 1,2 |
| Irganox 1076 | 2 | Phenolisches Antioxidans |

### Vergleichsbeispiel V1

| | | |
|---|---|---|
| Kraton G 1657 | 100 | SEBS mit 13 % Blockpolystyrolgehalt der Firma Kraton Das SEBS enthielt ca. 36% Zweiblockgehalt. |
| Escorez 5600 | 80 | Hydriertes KW-Harz mit einem Schmelzpunkt von 100°C der Firma Exxon |
| Ondina G 17 | 35 | Weißöl aus parafinischen und naphtenischen Anteilen der Firma Shell |

Die Bestandteile werden in einem Gemisch aus Benzin, Toluol und Aceton (6:2:2) gelöst und aus der Lösung auf einen unbehandelten PET-Träger (bzw. für die Permeationsmessungen auf ein mit 1,5 g/m² silikonisiertes Trennpapier) beschichtet und bei 120°C für 15 min getrocknet. Die Dicke der Klebeschicht beträgt 30 µm bzw. 50 µm.

### Vergleichsbeispiel V2

Es wurde ein Acrylat mit der Zusammensetzung 78% EHA, 19% Stearylacrylat und 3% Acrylsäure in Aceton und Benzin polymerisiert und aus der Lösung auf einen unbehandelten PET-Träger (bzw. für die Permeationsmessungen auf ein mit 1,5 g/m² silikonisiertes Trennpapier) beschichtet, bei 120°C für 15 min getrocknet und mit 0,2% Aluminiumchelat, bezogen auf den Anteil Polymer vernetzt. Die Dicke der Klebeschicht beträgt 30 µm bzw. 50 µm.

### Vergleichsbeispiel V3

Eine Mischung aus 60% Levamelt 456 (Etylen-Vinylacetat) und 40% Foral FG85 werden in Aceton gelöst und aus der Lösung auf einen unbehandelten PET-Träger (bzw. für die Permeationsmessungen auf ein mit 1,5 g/m² silikonisiertes Trennpapier) beschichtet und bei 120°C für 15 min getrocknet. Die Dicke der Klebeschicht beträgt 30 µm bzw 50 µm.

### Vergleichsbeispiel V4

Die kommerziell erhältliche Silikonhaftklebemasse Silgrip PSA529 von GE Bayer Silikons wird mit Benzoylperoxid abgemischt und aus der Lösung auf einen unbehandelten PET-Träger (bzw. für die Permeationsmessungen auf ein mit 1,5 g/m² fluorsilikonisiertes Trennpapier) beschichtet und bei 120°C für 15 min getrocknet und vernetzt. Die Dicke der Klebeschicht beträgt 30 µm bzw. 50 µm.

### Vergleichsbeispiel V5

| | | |
|---|---|---|
| Notio PN 0040 | 100 | Terpolymer aus Propylen mit den Comonomeren Buten-(1) und 4-Methylpenten-(1), Schmelzindex 4g/10min, Dichte 0,868 g/cm³, Biegemodul 42 MPa, Kristallitschmelzpunkt 159°C, Schmelzwärme 5,2 J/g, Elastizitätsmodul G' (23°C) 0,6 MPa, Verlustfaktor tan δ (23 °C) 0,14 |

### Ergebnisse

Die Ergebnisse der Permeationsmessungen sind in Tabelle 1 gezeigt. Es zeigt sich unter anderem der Einfluss des verwendeten Harzes auf die Permeationseigenschaften der Haftklebemassen. Durch unpolarere Harze mit hoher Erweichungstemperatur, wie dem Regalite R1100 in Beispiel 2 werden sowohl Wasserdampfpermeabilität (WVTR), als auch Sauerstoffpermeabilität (OTR) verringert.

**Tabelle 1**

| | WVTR g / (m²*Tag) | OTR g / (m²*Tag*bar) |
|---|---|---|
| Beispiel 1 | 120 | 9580 |
| Beispiel 2 | 23 | 6800 |
| Beispiel 3 | 67 | 10780 |
| Beispiel 4 | 61 | 12780 |
| Beispiel 5 | 47 | 13400 |
| Beispiel 6 | 20 | 2900 |
| Beispiel 7 | 42 | 10850 |
| Beispiel 8 | 32 | 6500 |
| V1 | 89 | 7280 |
| V2 | 320 | 40.250 |
| V3 | > 1.000 | 62.000 |
| V4 | > 1.000 | 75.000 |
| V5 | 29 | 14.100 |

Beispiel 1, Beispiel 4 und 5 und Beispiel 8 beinhalten unterschiedliche Polyolefine, die sich unter anderem durch ihre Kristallitschmelztemperatur und Zusammensetzung unterscheiden. Die Permeabilität ist bei Terpolymeren aus Propylen mit den Comonomeren Buten-(1) und 4-Methylpenten-(1), wie sie in den Beispielen 6 und 8 verwendet werden, am geringsten und damit besonders vorteilhaft.

In den Beispielen 7 und 6 ist eine vorteilhafte Verwendung des Weichmachers Polyisobutylen Oppanol B10 anstatt des Weißöls Ondina 933 in den weiteren Beispielen aufgezeigt. Hierdurch wird vor allem die Wasserdampfpermeation der Muster herabgesetzt.

Der Vergleich der Beispiele 6 und 8 mit dem Vergleichsbeispiel V5 zeigt die Vorteile der erfindungsgemäßen Haftklebemassen gegen Heißschmelzklebemassen auf gleicher Polymerbasis auf. Durch den Harzzusatz wird die Sauerstoffpermeabilität bei etwa gleich bleibender Wasserdampfpermeabilität weiter abgesenkt.

Im Vergleich zu anderen Typen von Haftklebemassen, etwa Acrylaten, Etylen-VinylAcetat oder Silikonen (Vergleichsbeispiel V2 bis V4) weisen die beschriebenen Haftklebemassen auf Basis von Polyolefinen eine geringe Permeabilität von Wasserdampf und Sauerstoff, aber insbesondere von Wasserdampf auf. Haftklebemassen auf Basis von Styrolblockcopolymeren, wie in Beispiel V1 zeigen eine ähnlich geringe Permeabilität, die aber durch besonders Vorteilhafte Ausführungen von Polyolefinhaftklebemassen übertroffen werden kann. Zusätzlich wird durch die erfindungsgemäßen Haftklebemassen eine höhere Haftung insbesondere auf unpolaren Oberflächen, wie etwa Polyethylen erreicht.

| | Klebkraft [N/cm] Stahl / PET/ PE |
|---|---|
| Beispiel 1 | 5,5 / 4,2 |
| Beispiel 2 | 8,5 / 5,7 |
| Beispiel 3 | 5,1 / 3,9 |
| Beispiel 4 | 5,3 / 3,5 |
| Beispiel 5 | 7,3 / 5,2 |
| Beispiel 6 | 9,5 / 5,5 |
| Beispiel 7 | 3,9/2,8 |
| Beispiel 8 | 12,2/5,9 |
| V1 | 3,7 / 1,9 |
| V2 | 6,2/3,1 |
| V3 | 4,5/0,8 |
| V4 | 4,5/2,9 |

Bei den Klebkräften zeigen die Polyolefinhaftklebemassen (Beispiel 1 bis 8) auch bei geringen Schichtdicken von ca. 30 µm eine gute Haftung auf polaren und unpolaren Untergründen und können in bestimmten Ausführungen die in den Permeationseigenschaften ähnlichen Styrolblockcopolymere (V1) bei den Klebkräften deutlich übertreffen.

| | Lebensdauer [t / h] |
|---|---|
| | |
| Beispiel 2 | 378 |
| Beispiel 6 | 405 |
| Beispiel 8 | 389 |
| V1 | 260 |
| V2 | 29 |
| V3 | 11 |
| V4 | 14 |
| V4 | 11 |

Durch die sehr gute Haftung auf unpolaren Oberflächen und die Sperrwirkung der erfindungsgemäßen Haftklebemassen insbesondere gegen Wasserdampf wird eine verlängerte Lebensdauer von optoelektronischen Aufbauten erreicht.

## Patentansprüche

1. Verfahren zur Kapselung einer elektronischen, vorzugsweise optoelektronischen, Anordnung gegen Permeanten
bei dem eine Haftklebemasse auf Basis eines teilkristallinen Polyolefins auf und/oder um die zu kapselnden Bereiche der elektronischen Anordnung appliziert wird,
wobei das Polyolefin eine Dichte zwischen 0,86 und 0,89 g/cm³ und einen Kristallitschmelzpunkt von mindestens 90°C aufweist und
das Polyolefin mit mindestens einem Klebharz in einer Menge von 130 bis 350 phr kombiniert ist.

2. Verfahren nach einem der vorhergehenden Ansprüche, **dadurch gekennzeichnet, dass** die Haftklebemasse in Form eines Klebebandes bereitgestellt wird.

3. Verfahren nach einem der vorhergehenden Ansprüche, **dadurch gekennzeichnet, dass** die Haftklebemasse und/oder die zu kapselnden Bereiche der elektronischen Anordnung vor, während und/oder nach der Applikation der Haftklebemasse erwärmt werden.

4. Verfahren nach einem der vorhergehenden Ansprüche, **dadurch gekennzeichnet, dass** die Haftklebemasse nach der Applikation auf der elektronischen Anordnung vernetzt wird.

5. Verfahren nach einem der vorhergehenden Ansprüche, **dadurch gekennzeichnet, dass** die Applikation der Haftklebemasse ohne anschließendes Aushärten erfolgt.

6. Verwendung einer Haftklebmasse zur Kapselung einer elektronischen, vorzugsweise optoelektronischen, Anordnung gegen Permeanten, insbesondere in einem Verfahren nach einem der vorhergehenden Ansprüche,
**dadurch gekennzeichnet,**
**dass** die Haftklebemasse auf Basis eines teilkristallinen Polyolefins hergestellt ist, dass das Polyolefin eine Dichte zwischen 0,86 und 0,89 g/cm³ aufweist und
**dass** das Polyolefin einen Kristallitschmelzpunkt von mindestens 90°C aufweist und das Polyolefin mit mindestens einem Klebharz in einer Menge von 130 bis 350 phr kombiniert ist.

7. Verwendung nach Anspruch 6, **dadurch gekennzeichnet,**
**dass** das Polyolefin eine Dichte zwischen 0,86 und 0,88 g/cm³, bevorzugt zwischen 0,86 und 0,87 g/cm³ aufweist und/oder
das Polyolefin einen Kristallitschmelzpunkt von mindestens 115°C, bevorzugt von mindestens 135°C aufweist.

8. Verwendung nach Anspruch 6 oder 7, **dadurch gekennzeichnet,**
**dass** das Polyolefin mit mindestens einem Klebharz kombiniert ist,
wobei die Menge an Klebharz 200 bis 240 phr beträgt.

9. Verwendung nach einem der Ansprüche 6 bis 8, **dadurch gekennzeichnet,**
**dass** die Haftklebemasse ein hydriertes Harz, vorzugsweise mit einem Hydrierungsgrad von mindestens 90%, besonders bevorzugt von mindestens 95%, enthält.

10. Verwendung nach einem der Ansprüche 6 bis 9, **dadurch gekennzeichnet,**
**dass** die Haftklebemasse ein oder mehrere Additive enthält,
vorzugsweise ausgewählt aus der Gruppe bestehend aus: Weichmacher, primären Antioxidanzien, sekundären Antioxidanzien, Prozessstabilisatoren, Lichtschutzmitteln, Verarbeitungshilfsmittel, UV-Blocker, Polymere

11. Verwendung nach einem der Ansprüche 6 bis 14, **dadurch gekennzeichnet,**
**dass** die Haftklebemasse einen oder mehrere Füllstoffe enthält, vorzugsweise nanoskalige Füllstoffe, transparente Füllstoffe und/oder Getter und/oder Scavenger-Füllstoffe.

12. Verwendung nach einem der Ansprüche 6 bis 11, **dadurch gekennzeichnet,**
**dass** die Haftklebemasse transparent ausgebildet ist,
vorzugsweise, dass die Haftklebemasse im Wellenlängenbereich von 400 nm bis 800 nm einem mittleren Transmissionsgrad von mindestens 75%, weiter bevorzugt von mindestens 90%, aufweist.

13. Verwendung nach einem der Ansprüche 6 bis 12, **dadurch gekennzeichnet,**
**dass** die Haftklebemasse UV-blockend im Wellenlängenbereich von 320 nm bis 400 nm ausgebildet ist, vorzugsweise im Wellenlängenbereich von 280 nm bis 400 nm, weiter vorzugsweise im Wellenlängenbereich von 190 nm bis 400 nm, wobei als UV-blockend ein mittlerer Transmissionsgrad von maximal 20%, vorzugsweise von maximal 10%, weiter bevorzugt von maximal 1% bezeichnet wird.

14. Verwendung nach einem der Ansprüche 6 bis 13, **dadurch gekennzeichnet,**
**dass** die Haftklebemasse als Klebeband, insbesondere als trägerfreies Klebeband, ausgebildet ist.

15. Elektronische Anordnung mit einer elektronischen Struktur, insbesondere einer organischen elektronischen Struktur, und einer Haftklebmasse,
wobei die elektronische Struktur zumindest teilweise durch die Haftklebmasse gekapselt ist,
**dadurch gekennzeichnet,**
**dass** die Haftklebmasse gemäß einem der Ansprüche 6 bis 14 verwendet ist.

## Claims

1. Method for encapsulating an electronic, preferably optoelectronic, arrangement against permeants,
in which a pressure-sensitive adhesive composition based on a partly crystalline polyolefin is applied onto and/or around the regions of the electronic arrangement which are to be encapsulated,
wherein the polyolefin has a density between 0.86 and 0.89 g/cm and a crystallite melting point of at least 90°C and the polyolefin is combined with at least one tackifier resin in an amount of 130 to 350 phr.

2. Method according to any of the preceding claims, **characterized in that** the pressure-sensitive adhesive composition is provided in the form of an adhesive tape.

3. Method according to any of the preceding claims, **characterized in that** the pressure-sensitive adhesive composition and/or the regions of the electronic arrangement which are to be encapsulated are heated before, during and/or after the application of the pressure-sensitive adhesive composition.

4. Method according to any of the preceding claims, **characterized in that** the pressure-sensitive adhesive composition is crosslinked after application on the electronic arrangement.

5. Method according to any of the preceding claims, **characterized in that** the application of the pressure-sensitive adhesive composition is effected without subsequent curing.

6. Use of a pressure-sensitive adhesive composition for encapsulating an electronic, preferably optoelectronic, arrangement against permeants, in particular in a method according to any of the preceding claims,
**characterized**
**in that** the pressure-sensitive adhesive composition is produced in a manner based on a partly crystalline polyolefin,
**in that** the polyolefin has a density of between 0.86 and 0.89 g/cm³, and
**in that** the polyolefin has a crystallite melting point of at least 90°C and the polyolefin is combined with at least one tackifier resin in an amount of 130 to 350 phr.

7. Use according to Claim 6, **characterized in that** the polyolefin has a density of between 0.86 and 0.88 g/cm³, preferably between 0.86 and 0.87 g/cm³, and/or
**in that** the polyolefin has a crystallite melting point of at least 115°C, preferably of at least 135°C.

8. Use according to Claim 6 or 7, **characterized in that** the polyolefin is combined with at least one tackifier resin,
wherein the amount of tackifier resin is 200 to 240 phr.

9. Use according to any of Claims 6 to 8, **characterized in that**
the pressure-sensitive adhesive composition contains a hydrogenated resin, preferably having a degree of hydrogenation of at least 90%, particularly preferably of at least 95%.

10. Use according to any of Claims 6 to 9, **characterized**
**in that** the pressure-sensitive adhesive composition contains one or more additives, preferably selected from the group consisting of: plasticizers, primary antioxidants, secondary antioxidants, process stabilizers, light stabilizers, processing assistants, UV blockers, polymers.

11. Use according to any of Claims 6 to 10, **characterized**
**in that** the pressure-sensitive adhesive composition contains one or more fillers, preferably nanoscale fillers, transparent fillers and/or getter and/or scavenger fillers.

12. Use according to any of Claims 6 to 11, **characterized**
**in that** the pressure-sensitive adhesive composition is embodied in transparent fashion, preferably in that the pressure-sensitive adhesive composition has an average transmittance of at least 75%, more preferably of at least 90%, in the wavelength range of 400 nm to 800 nm.

13. Use according to any of Claims 6 to 12, **characterized**
**in that** the pressure-sensitive adhesive composition is embodied in a UV-blocking fashion in the wavelength range of 320 nm to 400 nm, preferably in the wavelength range of 280 nm to 400 nm more preferably in the wavelength range of 190 nm to 400 nm, where an average transmittance of at most 20%, preferably of at most 10%, more preferably of at most 1%, is designated as UV-blocking.

14. Use according to any of Claims 6 to 13, **characterized**
**in that** the pressure-sensitive adhesive composition is embodied as an adhesive tape, in particular as a carrier-free adhesive tape.

15. Electronic arrangement comprising an electronic structure, in particular an organic electronic structure, and a pressure-sensitive adhesive composition,
wherein the electronic structure is at least partly encapsulated by the pressure-sensitive adhesive composition,
**characterized**
**in that** the pressure-sensitive adhesive composition is used in accordance with any of Claims 6 to 14.

## Revendications

1. Procédé d'encapsulation d'un système électronique et de préférence optoélectronique en vue de le protéger des agents perméants,
dans lequel une pâte adhésive à base de polyoléfine partiellement cristalline est appliquée sur et/ou autour des parties à encapsuler du système électronique,
la polyoléfine présentant une masse spécifique comprise entre 0,86 et 0,89 g/cm³ et un point de fusion des cristallites d'au moins 90°C et
la polyoléfine étant combinée avec au moins une résine adhésive à raison de 130 à 350 phr.

2. Procédé selon la revendication précédente, **caractérisé en ce que** la pâte adhésive est préparée sous la forme d'un ruban adhésif.

3. Procédé selon l'une des revendications précédentes, **caractérisé en ce que** la pâte adhésive et/ou les parties à encapsuler du système électronique sont chauffées avant, pendant et/ou après l'application de la pâte adhésive.

4. Procédé selon l'une des revendications précédentes, **caractérisé en ce que** la pâte adhésive est réticulée après avoir été appliquée sur le système électronique.

5. Procédé selon l'une des revendications précédentes, **caractérisé en ce que** la pâte adhésive est appliquée sans durcissement ultérieur.

6. Utilisation d'une pâte adhésive pour encapsuler un système électronique et de préférence optoélectronique en vue de le protéger des agents perméants, en particulier par un procédé selon l'une des revendications précédentes,
**caractérisée en ce que**
la pâte adhésive est préparée sur la base d'une polyoléfine partiellement cristalline,
**en ce que** la polyoléfine présente une masse spécifique comprise entre 0,86 et 0,89 g/cm³ et
**en ce que** la polyoléfine présente un point de fusion des cristallites d'au moins 90°C, la polyoléfine étant combinée avec au moins une résine adhésive à raison de 130 à 350 phr.

7. Utilisation selon la revendication 6, **caractérisée en ce que** la polyoléfine présente une masse spécifique comprise entre 0,86 et 0,88 g/cm³ et de préférence entre 0,86 et 0,87 g/cm³ et/ou **en ce que** la polyoléfine présente un point de fusion des cristallites d'au moins 115°C et de préférence d'au moins 135°C.

8. Utilisation selon les revendications 6 ou 7, **caractérisée en ce que** la polyoléfine est combinée avec au moins une résine adhésive, la teneur en résine adhésive étant comprise entre 200 et 240 phr.

9. Utilisation selon l'une des revendications 6 à 8, **caractérisée en ce que** la pâte adhésive contient une résine hydrogénée, de préférence à un degré d'hydrogénation d'au moins 90 % et de façon particulièrement préférable d'au moins 95 %.

10. Utilisation selon l'une des revendications 6 à 9, **caractérisée en ce que** la pâte adhésive contient un ou plusieurs additifs sélectionnés de préférence dans l'ensemble constitué des plastifiants, des antioxydants primaires, des antioxydants secondaires, des agents de stabilisation de processus, des agents de protection contre la lumière, des adjuvants de traitement, des agents de blocage des UV et des polymères.

11. Utilisation selon l'une des revendications 6 à 10, **caractérisée en ce que** la pâte adhésive contient une ou plusieurs charges, de préférence des charges nanoscopiques, des charges transparentes, des charges à agent sorbeur et/ou des charges à agent de piégeage.

12. Utilisation selon l'une des revendications 6 à 11, **caractérisée en ce que** la pâte adhésive est transparente et de préférence **en ce que** la pâte adhésive présente un degré moyen de transmission d'au moins 75 % et de façon plus préférable d'au moins 90 % dans la plage de longueurs d'ondes qui s'étend de 400 nm à 800 nm.

13. Utilisation selon l'une des revendications 6 à 12, **caractérisée en ce que** la pâte adhésive bloque les UV dans la plage de longueurs d'ondes qui s'étend de 320 nm à 400 nm, de préférence dans la plage de longueurs d'ondes qui s'étend de 280 nm à 400 nm, de façon encore plus préférable dans la plage de longueurs d'ondes qui s'étend de 190 nm à 400 nm, un degré moyen de transmission d'au moins 20 %, de préférence d'au plus 10 % et de façon encore plus préférable d'au plus 1 % désignant un blocage des UV.

14. Utilisation selon l'une des revendications 6 à 13, **caractérisée en ce que** la pâte adhésive est configurée sous la forme d'un ruban adhésif et en particulier de ruban adhésif exempt de support.

15. Système électronique doté d'une structure électronique, en particulier d'une structure électronique organique, et d'une pâte adhésive, la structure électronique étant au moins en partie encapsulée par la pâte adhésive,
**caractérisé en ce que**
la pâte adhésive utilisée est conforme à l'une des revendications 6 à 14.
